# EUROPÄISCHE PATENTSCHRIFT

(11) **EP 1 125 960 B1**
(45) Veröffentlichungstag und Bekanntmachung des Hinweises auf die Patenterteilung: **11.05.2005**
(21) Anmeldenummer: 01100119.5
(22) Anmeldetag: 12.01.2001
(51) Int. Cl.: C08G 59/68, C07F 9/22, C08K 5/5399, C08G 59/40

(54) **Latente Kombinationsverbindungen und latente Ammoniumsalze aus Epoxidharzhärter und Flammschutzmittel sowie daraus hergestellte Epoxidharz-Systeme und -Produkte**
A latent combination compound and a latent ammonium salt from an epoxy resin curing agent and a flame retardant, epoxy resin systems or -products made therefrom
Composé latent de combinaison et un sel d'ammonium latent à partir d'un agent durcisseur de résines époxydes et d'un agent retardant la flamme, systèmes- ou produits de résines époxydes qui en sont préparés

(30) Priorität: 09.02.2000 DE 10006592
(43) Veröffentlichungstag der Anmeldung: 22.08.2001
(73) Patentinhaber: Schill + Seilacher "Struktol" Aktiengesellschaft, 22113 Hamburg (DE)
(72) Erfinder: Sprenger, Stephan, 22113 Oststeinbek (DE); Utz, Rainer, 21029 Hamburg (DE); Döring, Manfred, 07778 Dorndorf-Steudnitz (DE); Ciesielski, Michael, 06217 Merseburg (DE)
(74) Vertreter: UEXKÜLL & STOLBERG

(56) Entgegenhaltungen:
- EP-A- 0 806 429
- DE-B- 1 154 624
- US-A- 3 224 889
- US-A- 3 324 889
- US-A- 3 328 319
- US-A- 3 359 276
- US-A- 3 595 873
- US-A- 4 308 197
- US-A- 4 880 892
- US-A- 5 830 973

## Beschreibung

Die Erfindung betrifft latente Kombinationsverbindungen aus Epoxidharzhärter und Flammschutzmittel. Weiterhin betrifft sie ein Verfahren, diese latenten Kombinationsverbindungen mit Wasser und/oder ein- oder mehrwertigen Hydroxyverbindungen umzusetzen, und die bei dieser Umsetzung entstehenden latenten Ammoniumsalze. Ausgewählte latente Ammoniumsalze sind nach einem alternativ vorgestellten Verfahren erhältlich. Die latenten Kombinationsverbindungen und latenten Ammoniumsalze können zur Herstellung von Einkomponentenharzsystemen und daraus zugänglichen Formkörpern und Überzügen mit flammhemmenden Eigenschaften, in heißhärtbaren Einkomponentenepoxidharz-Klebstoffen eingesetzt und bei Harzinjektionsverfahren verwendet werden. Die Erfindung umfaßt weiterhin Prepregs und Verbundwerkstoffe sowie Leiterplatten.

Es besteht ein Bedarf nach Epoxidharzsystemen, die bei Harzinjektionsverfahren verwendet werden können, die bei möglichst geringer definierter Temperatur vollständig aushärten, ausgezeichnete Materialeigenschaften zeigen und im Brandfall toxikologisch unbedenklich sind. Die bekannten Epoxidharzsysteme sind diesbezüglich nicht befriedigend, vor allem kommt es zu Problemen bei der Lagerung, die ausgehärteten Systeme zeigen nicht die gewünschten mechanischen Eigenschaften und sind im Brandfall toxikologisch bedenklich.

Zur Zeit sind nur wenige Epoxidharzsysteme bekannt, die in Harzinjektionsverfahren eingesetzt werden können. Bei dem System RTM6 der Firma Ciba-Geigy findet die Härtung bei zu hoher Temperatur (180 °C) über einen zu langen Zeitraum (2 Stunden) statt. Von der Firma 3M ist ein Ein-Komponenten-Epoxidharzsystem auf Basis eines Diglycidylethers von Fluoren-Bisphenol bekannt. Dieses System weist zwar gute bruchmechanische Kenndaten auf, härtet allerdings auch erst bei 180 °C. Die Bayer AG bietet unter dem Handelsnamen Blendur® ein Epoxiisocyanuratharz auf Basis von Diphenylmethandiisocyanat an, welches die Möglichkeit bietet, bei unterschiedlichen Temperaturen zu härten. Durch eine Nachhärtung bei ebenfalls zu hoher Temperatur (200 °C) können dann die entsprechenden Eigenschaften erzielt werden.

Niedrighärtende Epoxidharzsysteme (Härtung bei ca. 100 °C) mit ausreichend hoher Glasübergangstemperatur (T_{g} etwa 200 °C) können erhalten werden, wenn eine hohe Exothermie der Polymerisation erreicht wird. Dies wird vor allem durch anionische Homopolymerisation der Epoxidharze ermöglicht. Besonders gute Ergebnisse werden erhalten, wenn die Polymerisationsstarter, in der Epoxidharzchemie häufig Beschleuniger genannt, sprunghaft oder schlagartig freigesetzt werden. Dieses Prinzip wird als latente Beschleunigung bezeichnet und ist in Einkomponentenharzen realisiert. In der Epoxidharzchemie werden diese Beschleuniger durch mechanische Verkapselung oder durch Bildung von Chelatkomplexen desaktiviert. Durch Temperaturerhöhung werden die eigentlichen Beschleuniger-Substanzen wieder freigesetzt. Entscheidend ist besonders für die Anwendung in Harzinjektionsverfahren, daß diese Freisetzung ausgesprochen abrupt geschieht. Das ist eine essentielle Voraussetzung dafür, daß die Harzsysteme zwar bei erhöhter Temperatur (60 bis 80 °C) gut fließfähig verarbeitet werden können, nach geringfügiger weiterer Temperaturerhöhung (auf etwa 100 °C) aber schnell aushärten.

(Dem Fachmann ist bekannt, daß die Begriffe Härter und Beschleuniger in der Epoxidharzchemie nicht klar voneinander abgrenzbar sind, vor allem ist den Substanzen, die Epoxidharzsystemen zugesetzt werden, nicht entweder eine Härter- oder eine Beschleuniger-Wirkung zuweisbar. Beide Begriffe, "Härter" und "Beschleuniger", werden deshalb bei der Beschreibung dieser Erfindung benutzt, um die Fähigkeit der vorgestellten Substanzen auszudrücken, ein beliebiges Epoxidharzsystem zu härten oder die Härtung zu beschleunigen.)

Die bekannten Einkomponentenharze, die latent beschleunigt werden können, enthalten Lewis-Addukte von tertiären Aminen und erfüllen die Anforderungen nicht. Sie müssen bei tiefen Temperaturen gelagert werden und beschleunigen die Polymerisation ungleichmäßig, so daß ein Nachtemperm nach der eigentlichen Polymerisation notwendig ist.

Die Schriften US-A-3 632 427, US-A-3 642 698, US-A-3 635 894 und US-A-3 678 007 offenbarten Salze von Imidazolen mit Mineralsäuren. Die EP 0 589 166 B1 und EP 0 589 167 B1 offenbaren die Herstellung von Übergangsmetall-Heterocyclenkomplexen, die als latente Polymerisationskatalysatoren für Epoxidharze vorgeschlagen werden. Die erwähnten Verbindungen sind jedoch Feststoffe, die in Lösungsmitteln gelöst werden müssen und ihre Anwendung in Einkomponentenharzen, ihre Verwendung bei Harzinjektionsverfahren und in Verbundwerkstoffen verbietet sich, da durch Entmischung unvermeidbare Probleme auftreten, die die mechanischen Eigenschaften des Epoxidharz-Materials und -produktes verschlechtern.

Für Hochleistungsanwendungen sind zusätzliche Modifizierungsmittel (Modifier) notwendig, um spezielle Anforderungen an Material- und Werkstoffeigenschaften zu erreichen. Dabei handelt es sich vor allem um eine Verbesserung der Elastizität (NBR-Modifier) und des Brandverhaltens (FST-Modifier).

Moderne Epoxidharze sowie daraus hergestellte Produkte müssen vor allem einen Flammschutz aufweisen. Stand der Technik beim Flammschutz von Epoxidharzen ist die Verwendung von nichtreaktiven Flammschutzmitteln wie Aluminiumhydroxid, Magnesiumhydroxid, Ammoniumpolyphosphat oder rotem Phosphor bei Gußmassen und Beschichtungen. Sie sind preiswert und toxikologisch unbedenklich. Zur Erzielung eines ausreichenden Flammschutzes müssen aber relativ große Anteile zugesetzt werden. Da sich diese Flammschutzmittel wie nichtreaktive Füllstoffe verhalten und sich die mechanischen Eigenschaften deutlich verschlechtern, werden sie in Verbundwerkstoffen (Composites) nicht eingesetzt. Weiter eignen sie sich nicht für Harzinjektionsverfahren, da das zu durchtränkende Gewebe auf das Flammschutzmittel wie ein Filter wirkt. Stand der Technik bei Composites ist der Einsatz von Epoxidharzen, welche mit Tetrabrombisphenol A umgesetzt wurden. Oft wird auch Antimontrioxid als Synergist eingesetzt. Im Brandfall können jedoch bromierte Dioxine entstehen. Zudem wird der Brandort mit krebserregender Antimon-Flugasche und stark korrosiv wirkenden Säuren kontaminiert.

Flammschutzmittel, welche reaktiv in Epoxidharz eingebunden werden können, sind aus den DE 44 47 277 A1, DE 43 08 184 A1 und EP 0 806 429 A2 bekannt. Epoxidharzsysteme, denen diese Flammschutzmittel zugesetzt wurden, sind in ihren Verarbeitungseigenschaften jedoch unzureichend, vor allem sind vorreagierte Epoxidharze feuchtigkeitsempfindlich und nicht lagerstabil.

Die US-A-3 328 319 betrifft ein Verfahren zum Härten von Epoxidharzen mit Carbonsäureanhydriden unter Zugabe von bestimmten phosphororganischen Verbindungen, die als Härtungskatalysatoren wirken.

Aufgabe der vorliegenden Erfindung ist es demzufolge, Einkomponentenepoxidharzsysteme zu Herstellung von flammhemmend ausgerüsteten Produkten zur Verfügung zu stellen, wobei die einfache Auswahl einer bestimmten gewünschten Härtungstemperatur möglich sein muß. Die Epoxidharzsysteme sollen selbst ausgezeichnet lagerstabil, vor allem langzeitlagerstabil sein, und in Harzinjektionsverfahren eingesetzt werden können. Die durch Härtung erhaltenen neuartigen Epoxidharz-Materialien sollen ausgezeichnete mechanische Eigenschaften, z.B. Bruchfestigkeit und geringe Sprödigkeit, zeigen, und gleichzeitig ausgezeichnete Flammschutzeigenschaften besitzen, ohne im Brandfalle toxikologisch bedenklich zu sein.

Es wurde überraschend gefunden, daß diese Aufgabe durch neuartige chemische Verbindungen gelöst wird.

Die Erfindung betrifft u.a. eine Gruppe von Phosphinsäureamiden, für die im folgenden auch der Begriff "Latente Kombinationsverbindungen" verwendet wird, andererseits eine Gruppe von Ammonium-Phosphinaten, die auch als "Latente Ammoniumsalze" bezeichnet werden. Den vorgestellten erfindungsgemäßen chemischen Verbindungen ist gemein, daß sie bei Temperaturerhöhung in der Lage sind, das Epoxidharzsystem, dem sie zugesetzt wurden, zu härten, d.h. sie sind latente Härter/Beschleuniger; gleichzeitig ermöglichen sie die Flammfestausrüstung des Epoxidharzes und der daraus hergestellten Produkte.

Die Schemata 1-3 (siehe Ende der Beschreibung) zeigen einige wenige chemische Reaktionen, die die später beschriebenen Verfahren und Verbindungen besonders verdeutlichen.

### Schema 1

Schema 1 stellt Umsetzungen einer Substanz vor (PD 3710), die gemäß den später benutzten Termini die ringgeschlossene Form (intramolekularer Ester) eines Derivats der 4-Hydroxy-butan-1-Phosphinsäure darstellt.

Wird mit tertiärem Amin und Wasser umgesetzt, so kann Ringöffnung unter Bildung eines Ammoniumphosphinats 1-IIb (latentes Ammoniumsalz) erfolgen. Findet die Umsetzung von PD 3710 mit einem sekundären Amin statt, so kann sich ein labiles Phosphinsäureamid (latente Kombinationsverbindung) 1-I bilden, auf dessen möglichen Zerfall zu 1-III und 1-IIa später noch genauer eingegangen wird.

### Schema 2

Schema 2 zeigt mögliche Umsetzungen eines Derivats des Phospholans (Oxa-Phospholan). Bei der Reaktion mit einem sekundären Amin kann es zur Bildung des chemischen Gleichgewichts 2-V kommen (die obige Verbindung stellt wieder eine latente Kombinationsverbindung dar), wobei die Alkoholyse zu 2-VIIa führt, die Hydrolyse 2-VIa ergibt, während die Umsetzung mit einem tertiären Amin 2-VII ergibt. Die Verbindungen 2-VIa, 2-VIIa und 2-VIII sind im Sinne der bei der Beschreibung der vorliegenden Erfindung benutzten Terminologie latente Ammoniumsalze.

### Schema 3

Schema 3 zeigt mögliche Umsetzungen eines Derivats des Phospholans (Oxa-Phospholan) bei der Reaktion mit einem tertiären Amin. Unabhängig von der miteingesetzten Komponente - im Folgenden oft als Komponente (c) bezeichnet - kommt es zur Ringöffnung des Oxa-Phospholans: ist die Komponente (c) ein Alkohol, wird verestert (3-VIIb), ist die Komponente (c) Wasser, liegt u.U. die freie Carbonsäure vor (3-VIb). Sowohl 3-VIb als auch 3-VIIb sind Ammonium-Phosphinate (latente Ammoniumsalze).

Bei der Beschreibung der vorliegenden Erfindung bezeichnet der Einfachheit halber R⁰ Wasserstoff oder eine lineare oder verzweigte, gesättigte oder ungesättigte Kohlenwasserstoffgruppe mit 1 bis 100 Kohlenstoffatomen ist, die gegebenenfalls ein oder mehrere Heteroatome ausgewählt aus Sauerstoff, Stickstoff, Schwefel, Phosphor, Silicium und Halogen enthalten kann. In der Kohlenwasserstoffgruppe ist die Zahl der Heteroatome vorzugsweise beschränkt auf 3 Heteroatome je 10 Kohlenstoffatome, bevorzugt 1 Heteroatom je 10 Kohlenstoffatome. Besonders bevorzugt sind Kohlenwasserstoffgruppen, die 0 bis 2 Heteroatome enthalten.

### I. Latente Kombinationsverbindungen

Die o.g. Aufgabe wird durch latente Kombinationsverbindungen entsprechend Formel I 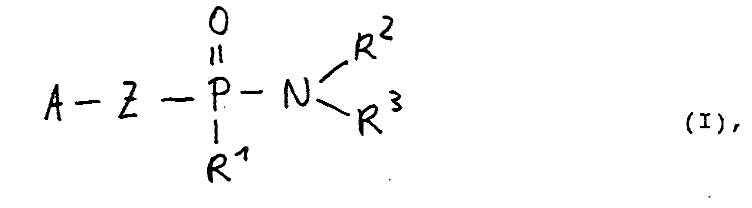
- in der R¹ die für R⁰ angegebene Bedeutung hat,
- R² und R³ unabhängig voneinander die für R⁰ angegebene Bedeutung haben, wobei R² und R³ unter Ausbildung eines Zyklus oder mehrerer Zyklen verknüpft sein können,
- A ausgewählt ist aus der Gruppe bestehend aus OH und COX, in der X ausgewählt ist aus der Gruppe bestehend aus OH, NH₂, NHR^{a}, NR^{b}R^{c}, OR^{d} oder O⁻M⁺ ist, wobei R^{a} bis R^{d} unabhängig voneinander die für R⁰ angegebene Bedeutung haben, R^{b} und R^{c} unter Ausbildung eines Zyklus oder mehrerer Zyklen verknüpft sein können und M⁺ ein beliebiges Metallkation ist, und
- Z eine zweiwertige lineare oder verzweigte, gesättigte oder ungesättigte Kohlenwasserstoffkette mit 2 bis 100 Kohlenstoffatomen bezeichnet, die gegebenenfalls ein oder mehrere Heteroatome ausgewählt aus Sauerstoff, Stickstoff, Schwefel, Phosphor, Silicium und Halogen enthalten kann,
gelöst. Die erfindungsgemäßen latenten Kombinationsverbindungen sind formal als Derivate von Phosphinsäure-Amiden aufzufassen, und zwar, in Abhängigkeit davon, ob R¹ Wasserstoff oder nicht Wasserstoff ist, von ein- oder zweifach am Phosphor substituierten Phosphinsäure-Amiden.

Bevorzugt sind die durch durch a) A-Z und b) R¹ in Formel I dargestellten Gruppen verschieden.

In der Gruppe Z kann die Zahl der Heteroatome auf 3 Heteroatome je 10 Kohlenstoffatome beschränkt sein, bevorzugt 1 Heteroatom je 10 Kohlenstoffatome. Besonders bevorzugt sind Gruppen Z, die 0 bis 2 Heteroatome enthalten. In einer anderen bevorzugten Ausführungsform weist die Gruppe Z in der Kette kein Heteroatom auf.

Im Allgemeinen ist die Gruppe R¹ bevorzugt keine reine Arylgruppe, z.B. ist sie nicht eine Phenylgruppe C₆H₅ oder eine von einer Phenylgruppe abgeleitete Arylgruppe ohne jeglichen aliphatischen Charakter. Bevorzugt ist die Gruppe R¹ ausgewählt aus den aus der EP 0 806 429 A2 bekannten sowie Methyl und Wasserstoff.

R¹ kann zum Beispiel Wasserstoff oder eine aliphatische, alicyclische oder aromatische Kohlenwasserstoffgruppe sein. Bei der Kohlenwasserstoffgruppe sind auch Kombinationen wie Alkylaryl- oder Arylalkylreste in Betracht zu ziehen, und sie kann darüber hinaus ein oder mehrere Heteroatome, ausgewählt aus Sauerstoff, Stickstoff, Schwefel, Phosphor, Silicium und Halogen enthalten. Bevorzugt ist die Kohlenwasserstoffgruppe eine aliphatische Kohlenwasserstoffgruppe, zum Beispiel Methyl. In einer anderen Ausführungsform enthält die Kohlenwasserstoffgruppe mindestens eine funktionelle Gruppe ausgewählt aus Epoxygruppen, α,β-Diolgruppen und Carbonsäure-, -ester- und -anhydridgruppen. Besonders bevorzugt ist R¹ ausgewählt aus Wasserstoff, Methyl und Kohlenwasserstoffgruppen, die mindestens eine Epoxyfunktion aufweisen. Funktionalisierte Kohlenwasserstoffgruppen, die an ein Phosphor-Atom eines Phosphinsäurederivats gebunden sind, sind zum Beispiel aus der EP 0 806 429 A2 bekannt.

Die bevorzugten erfindungsgemäßen latenten Kombinationsverbindungen lassen sich in zwei Klassen einteilen:
A) Latente Kombinationsverbindung nach Formel I in der A gleich OH ist. Bevorzugt enthält Z in der Kette 4 Kohlenstoffatome und enthält in der Kette keine Heteroatome. Besonders bevorzugt ist Z gleich But-1,4-diyl (1,4-Butylen) oder dessen Derivate.
   Zum Beispiel ist Z ausgewählt aus Biphen-2,2'-diyl und Derivat von Biphen-2,2'-diyl. Diese latenten Kombinationsverbindungen sind abgeleitet von den Amiden der 4-Hydroxybutan-1-phosphinsäure, besonders bevorzugt den Amiden der benzannelierten Derivate der 4-Hydroxy-butan-1-phosphinsäure. Diese benzannelierten Derivate der 4-Hydroxy-butan-1-phosphinsäure, z.B. die dem 9,10-Dihydro-9-oxa-10-phosphaphenanthren-10-oxid in seiner ringoffenene Form entsprechenden, sind in der EP 0 806 429 A2 beschrieben.
   In einer besonders bevorzugten Ausführungsform weist die Gruppe R¹ mindestens eine Epoxyfunktion auf. Unabhängig davon ist R¹ bevorzugt von der durch A-Z dargestellten Gruppe verschieden.
B) Latente Kombinationsverbindung nach Formel I in der A gleich COOH ist. R¹ ist gleich Methyl oder Wasserstoff, insbesondere Methyl. Z ist linear oder verzweigt und Alkan-(α,β)-diyl oder Arylalkan-(α,β)-diyl. In einer besonders bevorzugten Ausführungsform ist Z z.B. -CH₂CH₂-.

Unabhängig von den Ausführungsformen A) und B) ist R² bevorzugt nicht Wasserstoff; besonders bevorzugt sind sowohl R² als auch R³ nicht Wasserstoff. Letzteres ist z.B. in jenen Phosphinsäureamiden gemäß Formel I der Fall, die als NR²R³-Gruppe eine Imidazol-1-yl-Gruppe enthalten.

Beispiele für R² und R³ sind Wasserstoff oder eine Kohlenwasserstoffgruppe, die gegebenenfalls ein oder mehrere Heteroatome ausgewählt aus Sauerstoff, Stickstoff, Schwefel, Phosphor, Silicium oder Halogen enthält.

Bei den Kohlenwasserstoffgruppen kann es sich um lineare oder verzweigte Alkylgruppen, Cycloalkylgruppen, Arylgruppen, Alkylarylgruppen oder Arylalkylgruppen handeln, wobei auch Kombinationen der vorstehend genannten Möglichkeiten in Betracht zu ziehen sind. In einer bevorzugten Ausführungsform ist mindestens einer der Reste R² und R³ eine Kohlenwasserstoffgruppe, und diese Kohlenwasserstoffgruppe ist ausgewählt aus linearen oder verzweigten aliphatischen oder arylaliphatischen Kohlenwasserstoffgruppen. Die Kohlenwasserstoffgruppen R² und R³ können untereinander zu gesättigten oder ungesättigten Zyklen verknüpft sein, wobei Fünfringe und Sechsringe bevorzugt sind. Besonders bevorzugt ist die Verknüpfung von R² und R³ zu Fünf- oder Sechsringen, wobei in diesen Ringen weitere Heteroatome enthalten sein können. Bei der Verknüpfung zu Zyklen kann das Stickstoffatom eingebunden werden.

Sind R² und R³ zu einem Zyklus verknüpft, so kann die Funktion NR²R³ beispielsweise von Imidazol, 2-Methylimidazol und 2-Ethyl-4-methylimidazol abgeleitet sein.

Wie später ausgeführt wird, kann die erfindungsgemäße latente Kombinationsverbindung in ihrer der Formel I entsprechenden Form in Epoxidharzvorprodukten (z.B. in Einkomponentenharzsystemen) oder Epoxidharzfertigprodukten, z.B. Epoxidharzklebstoffen, vorteilhaft verwendet werden.

Es ist aber nicht zwingend vorgeschrieben, daß die erfindungsgemäßen latenten Kombinationsverbindungen in ihrer der Formel I entsprechenden Form in Substanz isoliert werden müssen. Bei der Herstellung von Substanzen, die von Formel I erfaßt werden, kann auf deren Isolierung verzichtet werden, sie können also in situ weiter verarbeitet werden. Dies ist beispielsweise, aber nicht ausschließlich, dann der Fall, wenn die latente Kombinationsverbindung nicht als solche eingesetzt werden soll.

Zum Beispiel zerfallen Lösungen der latenten Kombinationsverbindungen manchmal bei Raumtemperatur. So wird eine formal unter Formel I fallende (labile) latente Kombinationsverbindung, die durch Umsetzung einer ringgeschlossenen phosphorhaltigen Verbindung der Formel XV (R¹⁰ bis R¹⁸ gleich Wasserstoff) mit einem primären (H₂NR) oder sekundären (HNRR') aliphatischen Amin entstehen kann (dieses Verfahren ist Bestandteil der vorliegenden Erfindung), in Lösung zu
a) 50 mol-% einer Verbindung, die sich von Formel XV durch ersatzlosen Wegfall des exo-Sauerstoffatoms am Phosphor und Ersatz der Gruppe R¹⁸ durch die Aminogruppe (HNR oder NRR') herleitet (diese Teilreaktion verläuft unter Wasserabspaltung), und
b) 50 mol-% einer Verbindung zerfallen, die sich aus der Wasseranlagerung an die labile latente Kombinationsverbindung ergibt. Die durch Wasseraddition entstehende Verbindung entspricht der ringgeöffneten Form XXI (R¹⁸ gleich H), und zwar dem von dem primären oder sekundären Amin durch Protonierung abgeleiteten Ammonium-Phosphinat. Die vorliegende Erfindung betrifft, wie im Folgenden beschrieben, auch solche Ammonium-Phosphinate (latenten Ammoniumsalze).

### II. Latente Ammoniumsalze

Die Erfindung betrifft auch ein Verfahren, bei dem die latente Kombinationsverbindung gemäß Formel I mit mindestens einem Reagenz umgesetzt wird, wobei die P-N-Bindung der latenten Kombinationsverbindung hydrolytisch gespalten wird, sowie die durch das Hydrolyseverfahren zugänglichen latenten Ammoniumsalze.

Gemäß einer ersten möglichen Ausführungsform umfaßt das Reagenz Wasser.

Gemäß einer weiteren Ausführungsform wird eine latente Kombinationsverbindung, in der A gleich COOH ist, mit mindestens einem Reagenz umgesetzt, welches mindestens eine Verbindung ausgewählt aus Wasser und ein- oder mehrwertigen Hydroxyverbindungen umfaßt.

Bei der Umsetzung der latenten Kombinationsverbindung mit Wasser kommt es in einem ersten Reaktionsschritt immer zur Aufspaltung der in Formel I dargestellten P-N-Bindung, und es wird ein Ammoniumsalz der entsprechenden Phosphinsäure gebildet.

Dieses latente Ammoniumsalz kann gegebenenfalls wenn gewünscht isoliert werden.

So umfaßt der Begriff latentes Ammoniumsalz hier einerseits ein sich aus der Formel I ergebendes Ammonium-Phosphinat, wobei das Phosphinat-Phosphoratom entweder monosubstituiert ist (wenn R¹ gleich Wasserstoff ist) oder disubstituiert ist (wenn R¹ nicht Wasserstoff ist).

Dabei sollen die Bemerkungen zum Ammonium-Kation nicht bedeuten, daß das Ammonium-Kation im latenten Ammoniumsalz keine anderen Spezies als [H₂NR²R³]⁺ umfassen darf. Wenn z.B. das Reagenz, mit dem die erfindungsgemäße latente Kombinationsverbindung umgesetzt wird, neben Wasser eine oder mehrere der später erwähnten als Härter oder Beschleuniger bezeichneten stickstoffhaltigen Verbindungen, welche auch tertiäre Amine einschließen, umfaßt, dann umfaßt der Begriff Ammonium-Kation auch diese stickstoffhaltigen Verbindungen.

Das Ammonium-Kation des latenten Ammoniumsalzes ist von NR²R³ abgeleitet, ist demnach [H₂NR²R³]⁺ wobei in einer ersten bevorzugten Ausführungsform das Ammonium-Kation nicht NH₄⁺ ist, d.h. mindestens eine der Gruppen R² oder R³ soll von Wasserstoff verschieden sein. In einer anderen bevorzugten Ausführungsform umfaßt der Begriff Ammonium-Kation das NH₄⁺ und mindestens a) ein weiteres Ammonium-Kation, welches nicht NH₄⁺ ist und/oder b) eine der später genannten stickstoffhaltigen Verbindungen.

Außerdem gelten für das latente Ammoniumsalz die für R¹, R², R³, A, Z und A-Z für die erfindungsgemäße latente Kombinationsverbindung gemachten Angaben.

Für die Ammonium-Kationen gilt bevorzugt, daß - unabhängig von den im Folgenden diskutierten Ausführungsformen A) und B) der Phosphinat-Anionen - R² nicht Wasserstoff ist, besonders bevorzugt sind sowohl R² als auch R³ nicht Wasserstoff, dies ist z.B. dann der Fall, wenn das Ammonium-Kation von einer Imidazol-1-yl-Gruppe abgeleitet ist.

Bevorzugte Ammonium-Kationen sind die protonierten Formen von Imidazol, 2-Methylimidazol und 2-Ethyl-4-methylimidazol und 2-Ethyl-4-methylimidazol, wobei die Ammonium-Kationen diejenigen einschließen, die sich durch Protonierung des Stickstoffatoms in Formel I ergeben, wobei die bevorzugten Ausführungsformen der Reste R² und R³ oben ausgeführt sind.

Die bevorzugten Phosphinat-Anionen der erfindungsgemäßen latenten Ammoniumsalze lassen sich, unabhängig von den Ammonium-Kationen, in Analogie zu den für die latenten Kombinationsverbindungen gemachten Angaben in zwei Klassen einteilen:
A) Phosphinat-Kationen [(A-Z)(R¹)P(O)O]⁻, wobei A gleich OH ist. Bevorzugt enthält Z in der Kette 4 Kohlenstoffatome und enthält in der Kette keine Heteroatome. Besonders bevorzugt ist Z gleich But-1,4-diyl oder dessen Derivate.
   Zum Beispiel ist Z ausgewählt aus Biphen-2,2'-diyl und Derivat von Biphen-2,2'-diyl. Diese Phosphinat-Kationen sind abgeleitet von der 4-Hydroxy-butan-1-phosphinsäure, besonders bevorzugt den benzannelierten Derivaten der 4-Hydroxybutan-1-phosphinsäure, wie sie in der EP 0 806 429 A2 beschrieben sind. In einer besonders bevorzugten Ausführungsform weist die Gruppe R¹ mindestens eine Epoxyfunktion auf. Unabhängig davon ist R¹ bevorzugt von der durch A-Z dargestellten Gruppe verschieden.
B) Phosphinat-Kationen [(A-Z)(R¹)P(O)O]⁻, wobei A gleich COOH ist. Z ist linear oder verzweigt und Alkan-(α,β)-diyl oder Arylalkan-(α,β)-diyl, z.B. -CH₂CH₂-, und R¹ gleich Methyl. Diese Phosphinat-Kationen sind z.B. die (R¹-Derivate des) 2-Hydroxycarbonyl-ethyl-phosphinate, [(HOOCCH₂CH₂)(R¹)P(O)O]⁻.

Wird eine latente Kombinationsverbindung in dem Verfahren eingesetzt, in der A gleich COOH ist, so ist das Reagenz dadurch definiert, daß es mindestens eine Verbindung ausgewählt aus Wasser und ein- oder mehrwertigen Hydroxyverbindungen umfaßt. Das Reagenz muß also, wenn A gleich COOH ist, nicht zwingend Wasser enthalten. Beispielsweise wird bei dieser Ausführungsform in einem ersten Reaktionsschritt COOH der erfindungsgemäßen latenten Kombinationsverbindung mit mindestens einer ein- oder mehrwertigen Hydroxyverbindung verestert. Diese Reaktionsführung ist bevorzugt (siehe auch Beispiele 1-3). Das durch die Veresterung freigesetzte Wasser reagiert dann mit der P-N-Bindung in der latenten Kombinationsverbindung, was ebenfalls ein Ammonium-Phosphinat ergibt. Auch diese Ammoniumsalze, deren Bildung durch eine Veresterung eingeleitet wird, lösen die erfindungsgemäße Aufgabe und werden von dem Begriff latentes Ammoniumsalz miterfaßt. Dabei bevorzugte ein- oder mehrwertige Hydroxyverbindungen sind ein- und mehrwertige, lineare und verzweigte, aliphatische, arylaliphatische und aromatische Alkohole und Phenole, besonders ein- oder mehrwertige Alkohole und Phenole. Phenol selbst ist eine mögliche Hydroxyverbindung. Als mehrwertige Phenole sind hier beispielsweise zu nennen: Resorcin, Hydrochinon, 2,2-Bis-(4-hydroxyphenyl)-propan (Bisphenol A), Isomerengemische des Dihydroxydiphenylmethans (Bisphenol F), 4,4-Dihydroxydiphenylcyclohexan, 4,4'-Dihydroxy-3,3'-dimethyldiphenylpropan, 4,4'-Dihydroxydiphenyl, 4,4'-Dihydroxybenzophenon, Bis-(4-hydroxyphenyl)-1,1-ethan, Bis-(4-hydroxyphenyl)-1,1'-isobutan, Bis-(4-hydroxy-tert.-butylphenyl)-2,2-propan, Bis-(2-hydroxynaphthyl)-methan, 1,5-Dihydroxynaphthalin, Tris-(4-Hydroxyphenyl)-methan, Bis-(4-hydroxyphenyl)-1,1'-ether, wobei Bisphenol A und Bisphenol F hierbei besonders bevorzugt sind.

Selbstverständlich sind einwertige aliphatische Alkohole geeignet, zum Beispiel Methanol, Ethanol, sowie die isomeren (iso, tert., sec, n) Propanole, Butanole, Pentanole und Hexanole. Auch mehrwertige aliphatische Alkohole sind als Hydroxyverbindung geeignet. Als Beispiele derartiger mehrwertiger Alkohole seien 1,4-Butandiol, 1,6-Hexandiol, Polyalkylenglykole, Glycerin, Trimethylolpropan, Bis-(4-hydroxycyclohexyl)-2,2-propan, 1,2-Ethylenglykol, 1,2-Propylenglykol und Pentaerythrit genannt.

Der Begriff latentes Ammoniumsalz umfaßt auch diejenigen Ammoniumsalze, deren Bildung durch die Veresterung eines mehrwertigen Alkohols eingeleitet wird und die über die Alkoholgruppe verknüpfte Phosphinat-Einheiten enthält (siehe Beispiel 3).

Reagiert in dem ersten Reaktionsschritt das eingesetzte Wasser (oder, wenn A gleich COOH ist und eine Veresterung stattfindet, das bei der Veresterung entstehende Wasser) an einer anderen Position als der P-N-Bindung, ohne das die P-N-Bindung hydrolytisch gespalten wird, so wird bevorzugt weiter Wasser zugegeben, bis die P-N-Bindung gespalten wird.

Weiterhin kann es zur Umlagerung des latenten Ammoniumsalzes kommen. Zum Beispiel kann das Ammonium-Kation mit der Gruppe A reagieren, wenn die Gruppe A gleich COX ist, wobei das Amid gebildet wird und dementsprechend formal ein anderes Salz des Phosphinat-Anions vorliegt. Ist X gleich O⁻M⁺, dann liegt das Phosphinat nach Amidbildung formal als das Metallsalz vor und kann in andere Salze mit anderen Kationen überführt werden. In Schema 2 ist eine weitere dieser Umlagerungsreaktionen dargestellt: in dem Ammoniumphosphinat 2-VIII ist das Ammonium-Kation nicht von dem (hier sekundären) Amin abgeleitet, mit dem das Oxa-Phospholan zu 2-V umgesetzt wurde, sondern von einem (hier tertiären) Amin, welches später eingeführt wurde. Auch diese weiteren Umlagerungsprodukte werden von dem Begriff latentes Ammoniumsalz mitumfaßt.

### III. Verfahren zur Herstellung von latenten Kombinationsverbindungen und/oder latenten Ammoniumsalzen

Es wurde weiterhin überraschenderweise gefunden, daß sich die bevorzugten latenten Kombinationsverbindungen und latenten Ammoniumsalze dadurch besonders einfach herstellen lassen, daß man mindestens eine phosphorhaltige Verbindung (a) ausgewählt aus
i) Derivaten der 4-Hydroxy-butan-1-phosphinsäure und/oder ihres intramolekularen Esters entsprechend einer der Formeln X bis XXI 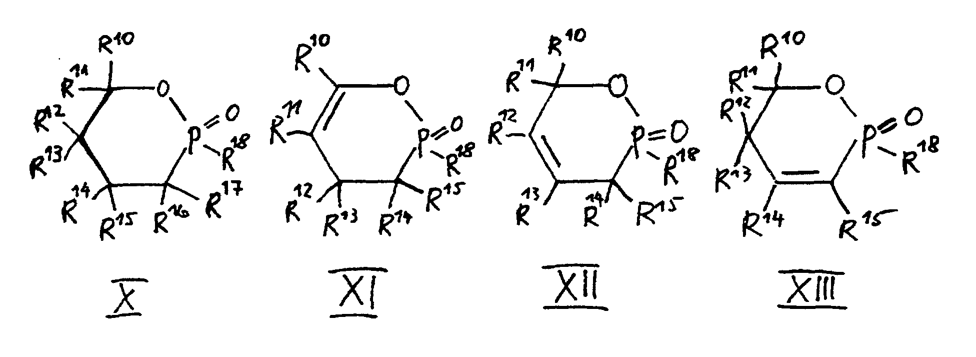 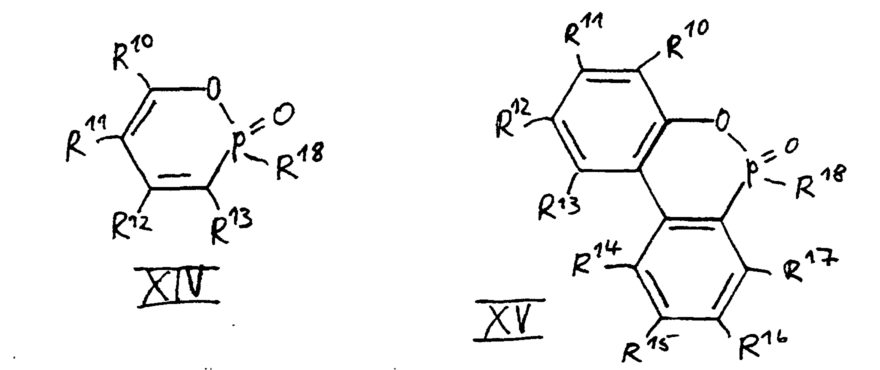 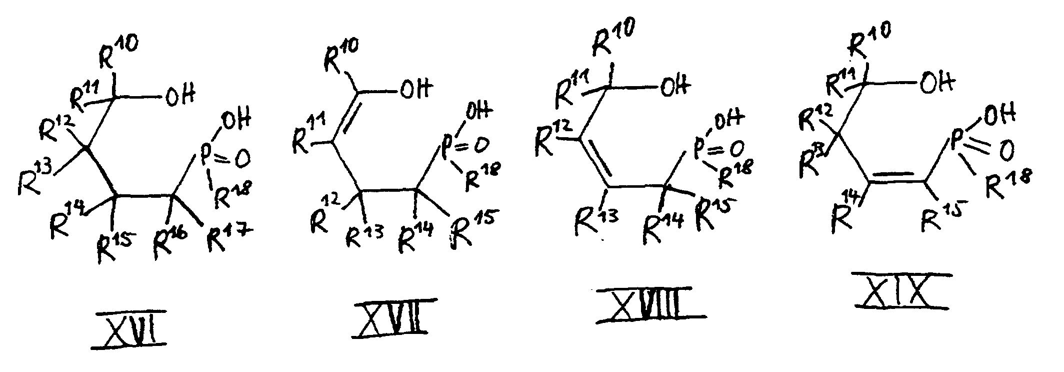 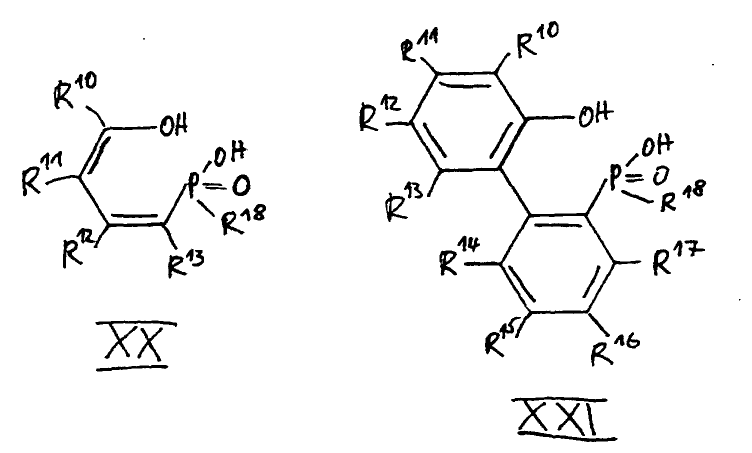 in denen R¹⁰ bis R¹⁸ unabhängig voneinander die für R⁰ angegebene Bedeutung haben, wobei zwei oder mehrere von R¹⁰ bis R¹⁷ unter Ausbildung eines Zyklus oder mehrerer Zyklen verknüpft sein können, und
ii) Derivaten des Phospholans entsprechend einer der Formeln XXX bis XXXIII 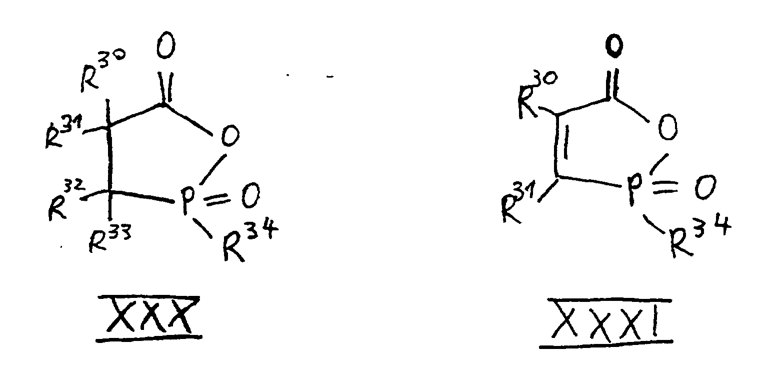 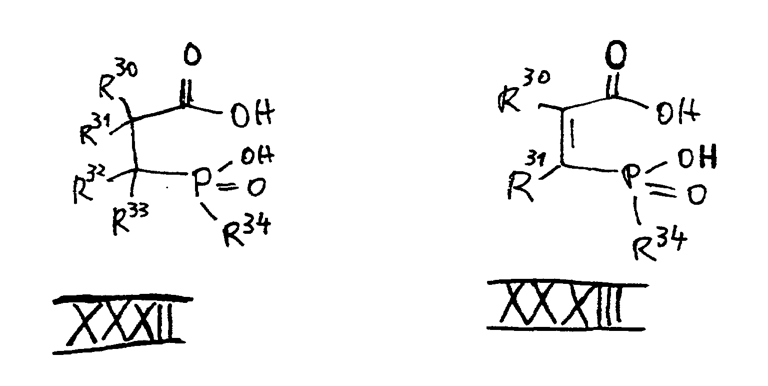 in denen R³⁰ bis R³⁴ unabhängig voneinander die für R⁰ angegebene Bedeutung haben und ein oder mehrere von R³⁰ bis R³³ unter Ausbildung eines Zyklus oder mehrerer Zyklen verknüpft sein können,
mit einer Komponente (b) umsetzt, die eine stickstoffhaltige Verbindung umfaßt. Die genauen Bedingungen, unter denen das erfindungsgemäße Verfahren abläuft, sind im Folgenden erläutert.

Die durch das erfindungsgemäße Verfahren der Umsetzung von Komponenten (a), (b) und gegebenfalls (c) zugänglichen latenten Kombinationsverbindungen und latenten Ammoniumsalze stellen bevorzugte Ausführungsformen der eingangs erwähnten erfindungsgemäßen latenten Kombinationsverbindungen und latenten Ammoniumsalze dar.

Bevorzugt wird bei dem Verfahren kein Phosphinsäureamid (latente Kombinationsverbindung) gebildet, sondern die Reaktion erfolgt zu einem latenten Ammoniumsalz ohne die in Formel I dargestellt P-N-Bindung.

Bevorzugte Komponenten (a) sind die aus der i) EP 0 806 429 A2 bzw. ii) DE 44 47 277 A1 bekannten phosphorhaltigen Verbindungen.

Beispiele für R¹⁸ und R³⁴ sind die für R¹ oben genannten.

Bei den Resten R¹⁰ bis R¹⁷ und R³⁰ bis R³³ handelt es sich unabhängig voneinander um Wasserstoff oder eine Kohlenwasserstoffgruppe, beispielsweise eine lineare oder verweigte aliphatische Kohlenwasserstoffgruppe. Bei den Kohlenwasserstoffgruppen kann es sich um lineare oder verzweigte Alkylgruppen, Cycloalkylgruppen, Arylgruppen, Alkylarylgruppen oder Arylalkylgruppen handeln, wobei auch Kombinationen der vorstehend genannten Möglichkeiten in Betracht zu ziehen sind. Die Kohlenwasserstoffgruppen können untereinander zu gesättigten und ungesättigten Zyklen verknüpft sein, wobei Fünf- und Sechsringe bevorzugt sind. Besonders bevorzugt ist die Verknüpfung zu Benzolkernen und Einbeziehung des Gruppengerüsts. Besonders bevorzugt sind die Reste R¹⁰ bis R¹⁷ und R³⁰ bis. R³³ jedoch frei von Heteroatomen. In einer weiteren Ausführungsform sind mehrere von R¹⁰ bis R¹⁷ und R³⁰ bis R³³ gleich Wasserstoff, zum Beispiel sind alle Reste R¹⁰ bis R¹⁷ und R³⁰ bis R³³ gleich Wasserstoff.

Der Begriff stickstoffhaltige Verbindung umfaßt die stickstoffhaltigen Verbindungen, die zur Ammoniumsalzbildung, d.h. Quaternisierung, befähigt sind. Dabei ist jedoch die Gegenwart von rein quartären Verbindungen oder Gruppen, z.B. Tetramethylammonium- oder N-Methylimidazolium-Salzen oder -Gruppen, nicht ausgeschlossen.

Bevorzugt ist die stickstoffhaltige Verbindung, auf die sich alle folgenden Anmerkungen beziehen, nicht NH₃. Dies soll nicht bedeuten, daß NH₃ bevorzugt nicht in der Komponente (b) enthalten sein darf oder daß die Umsetzung generell bevorzugt in Abwesenheit von NH₃ stattzufinden hat, sondern nur, daß wenn NH₃ vorhanden sein sollte, bevorzugt NH₃ nicht die einzige stickstoffhaltige Verbindung gemäß den folgenden Ausführungen ist.

Dabei kann die stickstoffhaltige Verbindung ein Ammoniumsalz (in der konventionellen Bedeutung des Begriffs) sein, d.h. sie enthält ein oder mehrere nicht mehr basische Gruppen (z.B. können in einem Polyamin mehrere Stickstoffatome quaterniert sein), solange die stickstoffhaltige Verbindung die zwingend vorgeschriebenen Bedingungen erfüllt. Diese Ammoniumgruppe kann hergeleitet sein von einer organischen oder einer Mineralsäure. Der Einfachheit halber wird in folgenden nicht immer ausdrücklich auf diese Salze Bezug genommen.

Bevorzugte stickstoffhaltige Verbindungen (b) sind die im Stand der Technik als Härter bzw. Beschleuniger bekannten. Üblicherweise werden Amine oder Imidazole verwendet, als stickstoffhaltige Verbindungen eignen sich aber auch Polyamine, Harnstoffe, Triazine, Triazole, Triazone, Pyrimidine, Thiodiazole und ähnliche Heterocyclen sowie Derivate der genannten. Beispielhafte stickstoffhaltige Verbindungen sind Tetramethylethylendiamin, Dimethyloctylamin, Dimethylaminoethanol, Dimethylbenzylamin, 2,4,6-Tris(dimethylaminomethyl)-phenol, N,N'-Tetramethyldiaminodiphenylmethan, N,N'-Dimethylpiperazin, N-Methylmorpholin, N-Methylpiperidin, N-Ethylpyrrolidin, 1,4-Diazabicyclo[2.2.2]-octan und Chinoline. Geeignete Imidazole sind beispielsweise 1-Methylimidazol, 2-Methylimidazol, 1,2-Dimethylimidazol, 1,2,4,5-Tetramethylimidazol, 2-Ethyl-4-methylimidazol, 1-Cyanoethyl-2-phenylimidazol und 1-(4,6-Diamino-s-triazinyl-2-ethyl-)-2-phenylimidazol. Davon sind 1-Methylimidazol und Dimethylbenzylamin besonders bevorzugt. Als stickstoffhaltige Verbindung sind ferner Imidazol, 2-Methylimidazol und 2-Ethyl -4-methylimidazol bevorzugt.

Bevorzugte aliphatische Amine sind diejenigen Amine, die sich von der Gruppe NR²R³ ableiten, wobei die Reste R² und R³ die oben ausgeführte Bedeutung haben.

Im folgenden sind mögliche Ausführungsformen des erfindungsgemäßen Verfahrens zur Umsetzung der phosphorhaltigen Komponente (a) mit der Komponente (b) erläutert:

### X) Umsetzung ringgeschlossener phosphorhaltiger Komponente (a) mit Komponente (b), welche keine stickstoffhaltige Verbindung mit basischer NH-Funktion aufweist

In einer ersten Ausführungsform befindet sich die phosphorhaltige Komponente (a) in ihrer ringgeschlossenen Form. Dies bedeutet, zum Beispiel, daß es sich bei der Ausführungsform i) um ein Derivat des intramolekularen Esters der 4-Hydroxybutan-1-phosphinsäure bzw. um den intramolekularen Ester der 4-Hydroxybutan-1-phosphinsäure (Formeln X-XV) oder ii) ein Derivat des intramolekularen Anhydrids der 2-Hydroxycarbonyl-ethyl-phosphinsäure bzw. das intramolekulare Anhydrid der 2-Hydroxycarbonyl-ethyl-phosphinsäure (Formeln XXX und XXXI) handelt. Sollte in diesem Fall die Umsetzung mit einer stickstoffhaltigen Verbindung gewünscht sein, die keine basische NH-Funktion aufweist, so ist es notwendig, um die Ringöffnung der phosphorhaltigen Komponente (a) zu erreichen, das erfindungsgemäße Verfahren so durchzuführen, daß es die Umsetzung mit mindestens einer Komponente (c) mit einschließt, wobei die Komponente (c) ausgewählt ist aus Wasser und ein- oder mehrwertigen Hydroxyverbindungen. Dabei muß das Verfahren nicht so durchgeführt werden, daß die Komponente (a) zuerst mit der Komponente (c) umgesetzt wird. Es ist auch möglich, Komponenten (b) und (c) zu mischen, und dann zur Komponente (a) zuzugeben, und es ist ebenso möglich, Komponente (a) und Komponente (b) zu mischen und dann Komponente (c) zuzugeben. Bevorzugte ein- oder mehrwertige Hydroxyverbindungen sind die im Abschnitt "Latente Ammoniumsalze" bereits erwähnten ein- oder mehrwertigen Hydroxyverbindungen, bevorzugt die genannten aliphatischen ein- oder mehrwertigen Alkohole und ein- oder mehrwertigen Phenole.

Dabei ist es möglich, daß die Ringöffnung der ringgeschlossenen Form der Komponente (a) unter Reaktion der Komponente (a) mit der Komponente (c) abläuft. Ist, zum Beispiel, die Komponente (a) i) von der ringgeschlossenen Form der 4-Hydroxy-butan-1-phosphinsäure abgeleitet, dann kann es durch die Umsetzung mit einer ein- oder mehrwertigen Hydroxyverbindung zur Veretherung kommen, wobei zum Beispiel eine in 4-Position veretherte Butanphosphinsäure gebildet werden kann. Ist die Komponente (a) ii) von der ringgeschlossenen Form der 2-Hydroxycarbonyl-ethyl-phosphinsäure abgeleitet, so kann es zum Beispiel zur Veresterung der Carbonsäuregruppe kommen, wodurch eine in 2-Position Carbonsäureesterfunktionalisierte Ethylphosphinsäure gebildet werden kann.

Ist die Hydroxyverbindung eine mehrwertige Hydroxyverbindung, so kann es zur Verknüpfung von mehreren Phosphinsäuregruppen kommen.

### Y) Umsetzung ringgeschlossener phosphorhaltiger Komponente (a) mit Komponente (b), welche eine stickstoffhaltige Verbindung umfaßt, die mindestens eine basische NH-Funktion aufweist

Liegt die Komponente (a) in der ringgeschlossenen Form vor, dann kann das erfindungsgemäße Verfahren so durchgeführt werden, daß eine Umsetzung unter Ringöffnung dann erreicht wird, wenn die Komponente (b) eine stickstoffhaltige Verbindung umfaßt, welche mindestens eine basische NH-Funktion besitzt. Weiterhin kann (können) jedoch selbstverständlich eine (oder mehrere) stickstoffhaltige Verbindung(en) zum Einsatz kommen, die keine basische NH-Funktion besitzt (besitzen).

### Z) Umsetzung ringoffener phosphorhaltiger Komponente (a) mit Komponente (b), welche eine stickstoffhaltige Verbindung umfaßt

Liegt die phosphorhaltige Komponente (a) in der ringoffenen Form vor (Formeln XVI-XXI, XXXII und XXXIII), dann besteht das erfindungsgemäße Verfahren darin, daß die Komponente (a) mit einer Komponente (b) umgesetzt wird, wobei die Komponente (b) eine stickstoffhaltige Verbindung umfaßt.

Das erfindungsgemäße Verfahren zur Herstellung einer latenten Kombinationsverbindung oder eines latenten Ammoniumsalzes wird gemäß den Ausführungsformen Y) und Z) bevorzugt so durchgeführt, daß es die Umsetzung mit mindestens einer Komponente (c) (die in der Ausführungsform X) zwingend vorgeschrieben ist) umfaßt, wobei die Komponente (c) mindestens eine Verbindung ausgewählt aus Wasser und ein- oder mehrwertigen Hydroxyverbindungen enthält.

### IV. Die erfindungsgemäßen Verfahren

Bei der folgenden Diskussion der erfindungsgemäßen Verfahren bezieht sich der Ausdruck "molar" auf Mol-Äquivalente. Dies bedeutet beispielsweise für die ein- oder mehrwertige Hydroxyverbindung (und analoges gilt für die stickstoffhaltige Verbindung), daß ein Mol-Äquivalent 1/n-tel der Stoffmenge der n-wertigen Hydroxyverbindung ist.

Die erfindungsgemäßen Verfahren, d.h das Verfahren der Hydrolyse der latenten Kombinationsverbindung und die Umsetzung der Komponenten (a), (b) und gegebenenfalls (c), sind nicht auf molare Umsetzungen beschränkt. Zum Beispiel kann es gewünscht sein, die latente Kombinationsverbindung nur mit einem submolaren Menge Reagenz zu hydrolysieren, was ein Gemisch von latenter Kombinationsverbindung und latentem Ammoniumsalz ergeben könnte. Es kann auch gewünscht sein, das erfindungsgemäße Verfahren der Umsetzung mindestens einer phosphorhaltigen Komponente (a) mit mindestens einer stickstoffhaltigen Komponente (b), und gegebenenfalls Komponente (c), mit einem molaren Unterschuß an Komponente (b), bezogen auf Komponente (a) durchzuführen, oder das Verfahren mit einem molaren Überschuß an Komponente (b), bezogen auf Komponente (a) durchzuführen.

In einer besonders bevorzugten Ausführungsform werden Komponente (a), Komponente (b) und gegebenenfalls Komponente (c) in einem molaren Verhältnis umgesetzt, d.h. in beliebiger Reihenfolge zueinander zugegeben.

Die erfindungsgemäßen Verfahren sind üblicherweise mit einer chemischen Reaktionsgleichung beschreibbar, ausgewählte Reaktionen sind in den Schemata 1-3 dargestellt. Bei der Durchführung der Verfahren ist es möglich, daß in überlagerten Reaktionen weitere Umlagerungen der erfindungsgemäßen latenten Kombinationsverbindungen oder latenten Ammoniumsalze erfolgen. Eine solche überlagerte Reaktion kann beispielsweise unter formaler Abspaltung von Wasser verlaufen, z.B. kann diese Wasserabspaltung intramolekular oder intermolekular sein und auf Veresterung, Veretherung, Anhydridbildung, Amidbildung etc. zurückgehen. Ein Beispiel ist die in Schema 1 von 1-I zu 1-III verlaufende Deydratisierungsreaktion, auf die bereits eingegangen wurde. Dieses Reaktionswasser kann in das erfindungsgemäße Verfahren eingreifen, in Schema 1 ist dies am Beispiel der Hydrolyse von 1-I zu 1-IIa dargestellt. Die Vielzahl solcher möglicher überlagerter Reaktionen kann zu Gemischen von latenten Kombinationsverbindungen und latenten Ammoniumsalzen (sowie gegebenenfalls weiteren Verbindungen) führen. Gemische können auch entstehen, wenn keine molare Umsetzung in dem gewählten erfindungsgemäßen Verfahren erfolgt. Gemische können die dieser Erfindung zugrundeliegende Aufgabe lösen, denn die vorliegende Erfindung schließt weitere Verbindungen, neben den erfindungsgemäßen latenten Kombinationsverbindungen und latenten Ammoniumsalzen, ausdrücklich nicht aus. Der Begriff "Verbindung", wie er in der Beschreibung dieser Erfindung verwendet wird, umfaßt auch diese Gemische.

### V. Verwendung der erfindungsgemäßen latenten Kombinationsverbindungen und latenten Ammoniumsalze

Die Erfindung betrifft weiterhin die Verwendung der latenten Kombinationsverbindungen und latenten Ammoniumsalze in Einkomponentenepoxidharzsystemen zur Herstellung von Überzügen und Formkörpern. Beispielsweise werden die Substanzen und Substanzmischungen in lagerstabilen, heißhärtenden Einkomponentenepoxidharz-Klebstoffen eingesetzt. Weiterhin betrifft die Erfindung Erzeugnisse, die unter der Verwendung der obengenannten Substanzen hergestellt worden sind. Als Beispiele für derartige Erzeugnisse seien genannt:
- Prepregs und Verbundwerkstoffe auf der Basis von anorganischen oder organischen Verstärkungsmaterialien in Form von Fasern, Vliesen oder Geweben, oder von Flächenstoffen;
- Leiterplatten, hergestellt aus Glasfasergewebe und Epoxidharzsystemen;
- Formkörper aller Art;
- Erzeugnisse mit Überzügen aus Epoxidharz; und
- Verklebungen verschiedener Substrate, z.B. Metallverklebungen im konstruktiven Bereich des Automobilbaus.

Neben der später ausgeführten Epoxidharzkomponente kann das Epoxidharzsystem weiterhin ein Lösungs-(Verdünnungs)mittel umfassen. Dieses Lösungs-(Verdünnungs)mittel kann aus der Herstellung der erfindungsgemäßen latenten Kombinationsverbindung bzw. dem erfindungsgemäßen latenten Ammoniumsalz stammen, zum Beispiel wenn diese nach einem erfindungsgemäßen Verfahren hergestellt wurden. Dann wurde das erfindungsgemäße Verfahren in diesem Lösungsmittel durchgeführt. Das Lösungs-(Verdünnungs)mittel kann man aber auch später in das Epoxidharzsystem einführen.

Beispielhafte Lösungsmittel sind aprotisch und besitzen vorzugsweise polaren Charakter. Beispiele hierfür sind: N-Methylpyrrolidon; Dimethylformamid; Ether, wie Diethylether, Tetrahydrofuran, Dioxan, Ethylenglykol-mono- bzw. -diether, Propylenglykol-mono- bzw. -diether, Butylenglykol-mono- bzw. -diether von Monoalkoholen mit einem gegebenenfalls verzweigten Alkylrest von 1 bis 6 Kohlenstoffatomen; Ketone, wie beispielsweise Aceton, Methylethylketon, Methylisopropylketon, Methylisobutylketon, Cyclohexanon und ähnliche; Ester, wie Ethylacetat, Butylacetat, Ethylglykolacetat, Methoxypropylacetat; halogenierte Kohlenwasserstoffe; jedoch sind auch auch (cyclo)aliphatische und/oder aromatische Kohlenwasserstoffe, wie Hexan, Heptan, Cyclohexan, Toluol, die verschiedenen Xylole sowie aromatische Lösungsmittel möglich. Die Lösungsmittel können dabei einzeln oder im Gemisch eingesetzt werden.

Die erfindungsgemäßen latenten Kombinationsverbindungen und latenten Ammoniumsalze (erfindungsgemäße Verbindungen) können Gemischen auf Basis von Epoxidharzverbindungen als reaktiver Bestandteil zugesetzt werden und auf diese Weise zur latenten Härtung/Beschleunigung und Flammfestausrüstung des vernetzten Epoxidmaterials verwendet werden. Hierbei kann die eingesetzte Menge der erfindungsgemäßen Verbindungen in weiten Grenzen schwanken, im allgemeinen verwendet man 0,1 bis 100 Gewichtsteile, bezogen auf 100 Gewichtsteile Epoxidharz, bevorzugt 0,5 bis 30 Teile. Es ist bekannt, daß für bestimmte Anwendungen, z.B. Leiterplatten, bis zu 30 Gew.-% Flammschutzmittel notwendig sind, um die entsprechenden Spezifikationen zu erreichen. Die günstigste Menge von latenten Kombinationsverbindungen und latenten Ammoniumsalzen im jeweiligen Epoxidharzsystem hängt zum Beispiel von der Natur des Epoxidharzes und von der Art und Anwesenheit anderer Komponenten - auch Flammschutzmittel und Co-Härter/Beschleuniger - ab und kann im Einzelfall vom Fachmann in einfacher und schneller Weise durch wenige Versuche festgelegt werden, wobei das Epoxidharzsystem ein breites oder auch ein sehr spezifisches Einsatzpotential haben kann.

Als Epoxidharzkomponenten kommen hierbei praktisch alle bekannten Verbindungen in Frage, die im Durchschnitt mehr als eine 1,2-Epoxidgruppe im Molekül besitzen. Solche Harze können eine aliphatische, aromatische, cycloaliphatische, arylaliphatische oder heterocyclische Struktur haben; sie enthalten Epoxidgruppen als Seitengruppen, oder diese Gruppen bilden einen Teil eines alicyclischen oder heterocyclischen Ringsystems. Epoxidharze dieser Typen sind allgemein bekannt und im Handel erhältlich. Beispielhaft für Epoxidharze dieses Typs sind zu erwähnen:
I) Polyglycidyl- und Poly-(β-methylglycidyl)-ester erhältlich durch Umsetzung einer Verbindung mit mindestens zwei Carboxylgruppen im Molekül und Epichlorhydrin bzw. Glycerindichlorhydrin bzw. β-Methylepichlorhydrin.
II) Polyglycidyl- oder Poly-(β-methylglycidyl)-ether erhältlich durch Umsetzung einer Verbindung mit mindestens 2 freien alkoholischen Hydroxygruppen und/oder phenolischen Hydroxygruppen und einem geeignet substituierten Epichlorhydrin unter alkalischen Bedingungen, oder in Anwesenheit eines sauren Katalysators und anschließende Alkalibehandlung.
III)Poly-(N-glycidyl)-Verbindungen.
IV) Poly-(S-glycidyl)-Verbindungen.
V) Epoxidverbindungen, worin die Epoxidgruppen einen Teil eines alicyclischen oder heterocyclischen Ringsystems bilden.

Natürlich können auch Mischungen von Epoxidharzen eingesetzt werden.

Die Erfindung betrifft auch Zusammensetzungen, die eine latente Kombinationsverbindung oder ein latentes Ammoniumsalz zusammen mit einem Epoxidharz enthalten, und Zusammensetzungen, die ein vorverlängertes Epoxidharz auf Basis einer der erfindungsgemäßen Verbindungen enthalten. (Vorverlängerte Epoxidharze sind noch freie Epoxidgruppen aufweisende vorreagierte Addukte eines oder mehrerer Epoxidharze mit einer oder mehreren Verbindungen, die mindestens zwei funktionelle Gruppen pro Molekül enthalten, die mit Epoxidgruppen reagieren.)

Die erfindungsgemäßen Zusammensetzungen, wie Einkomponentenepoxidharzsysteme und Einkomponentenepoxidharz - klebstoffe, können außerdem weitere übliche Zusätze und Modifizierungsmittel in einer für den jeweiligen Zweck geeigneten Menge enthalten, wie zum Beispiel Hitzestabilisatoren, Lichtstabilisatoren, UV-Absorber, Antioxidantien, antistatische Mittel, Konservierungsmittel, Haftvermittler, Füllstoffe, Pigmente, Schmierstoffe, Verschäumungsmittel, Fungizide, Weichmacher, Verarbeitungshilfsmittel, weitere flammhemmende Zusätze, weitere Härter/Beschleuniger und Mittel zur Verringerung der Rauchentwicklung.

In einer bevorzugten Ausführungsform wird das Epoxidharzsystem in einem Harzinjektionsverfahren verarbeitet. Die dafür nötige ausreichende Verarbeitungsstabilität bei mittleren Temperaturen sowie kurze Härtungszeit bei höheren Temperaturen werden durch die erfindungsgemäßen latenten Kombinationsverbindungen und latenten Ammoniumsalze dieser Erfindung möglich. Außerdem macht die Möglichkeit vergleichsweise geringer Aushärttemperaturen die Systeme auch für die rationelle Verarbeitung von Klebstoffen interessant.

Ein bevorzugtes Harzinjektionsverfahren für faserverstärkte Verbundwerkstoffe mit flammhemmenden Eigenschaften ist dadurch gekennzeichnet, daß es umfaßt
a.) Imprägnieren eines anorganischen oder organischen Verstärkungsmaterials in Form von Fasern, eines Vlieses, Gewebes oder Flächenstoffes mit einem erfindungsgemäßen Einkomponentenepoxidharzsystem und
b.) Härten des imprägnierten Verstärkungsmaterials bei einen Temperatur zwischen 70 °C und 160 °C, insbesondere 90 °C und 140 °C.

Außerdem betrifft die Erfindung ein Verfahren zur Herstellung von faserverstärkten Verbundwerkstoffen mit flammhemmenden Eigenschaften, das dadurch gekennzeichnet ist, daß es die Härtung eines erfindungegemäßen Prepregs bei einer Temperatur zwischen 70 °C und 160 °C, insbesondere 90 °C und 140 °C, umfaßt.

Ferner betrifft die Erfindung einen faserverstärkten Verbundwerkstoff mit flammhemmenden Eigenschaften, der die gehärtete Form eines erfindungsgemäßen Prepregs ist.

Die durch die vorliegende Erfindung zugänglichen latenten Kombinationsverbindungen und latenten Ammoniumsalze können flüssig sein und bieten gegenüber den herkömmlichen Härtern, welche Feststoffe darstellen, zahlreiche Verarbeitungsvorteile. Insbesondere kann mit den neuartigen Einkomponentenepoxidharzsystemen das Problem der Entmischung der Härter/Beschleuniger-Komponente aus dem Harz während der Lagerung und/oder Härtung überwunden werden. Weiterhin sind die erfindungsgemäßen Epoxidharzsysteme bei mittleren Temperaturen in Harzinjektionssystemen leicht verarbeitbar, während sie bei etwas höheren Temperaturen vollständig aushärten.

Das Epoxidharzsystem umfaßt mindestens eine Epoxidharzkomponente und mindestens eine der erfindungsgemäßen latenten Kombinationsverbindungen oder latenten Ammoniumsalze, wobei der Einsatz von Gemischen von latenter Kombinationsverbindung und latentem Ammoniumsalz, miteinander und/oder mit weiteren Bestandteilen (z.B. den genannten Zusätzen und Modifizierungsmitteln), im beliebigen Verhältnis, möglich ist.

Die durch diese Erfindung zugänglichen Epoxidharzsysteme weisen eine definierte Härtungstemperatur auf, was durch eine Latenz der erfindungsgemäßen Verbindungen erreicht wird. Die Initiierungstemperatur wird durch chemische Modifikation der latenten Kombinationsverbindungen und latenten Ammoniumsalze eingestellt. Außerdem werden die Produkte, die aus den durch die Erfindung zugänglichen neuartigen Einkomponentenharzen hergestellt werden, flammhemmend ausgerüstet.

### VI. Beispiele

### Beispiel 1

Es wurde eine phosphorhaltige Komponente (a) der ringgeschlossenen Formel XXX verwendet, in der R³⁰ bis R³³ gleich Wasserstoff waren und R³⁴ Methyl war:

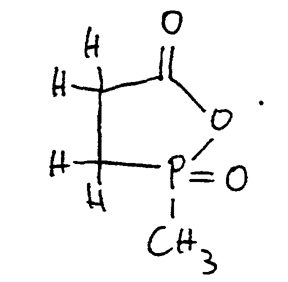

Als Komponente (b) wurde 1-Methylimidazol (N-Methylimidazol) gewählt, und Komponente (c) ist Methanol.

Die Umsetzung der Komponenten (a), (b) und (c) kann in beliebiger Reihenfolge erfolgen und ergibt in allen Fällen 1-Methylimidazolium-(2-methoxycarbonyl-ethyl)(methyl)phosphinat. Dieses erfindungsgemäße latente Ammoniumsalz ist bei Raumtemperatur flüssig. Eine Mischung von 10 Gew.-% latentes Ammoniumsalz und 90 Gew.-% Epoxidharz wurde hergestellt. Das System ist, unabhängig vom Harztyp, bei Raumtemperatur lagerstabil, und härtet auch bei 70 °C mehrere Stunden lang nicht, was seine Eignung für die Anwendung in Harzinjektionsverfahren verdeutlicht.

Bei 125 °C erfolgt innerhalb von 15 Minuten eine komplette Härtung. Der Glasumwandlungspunkt T_{g} (DSC, Heizrate 10K/min) wurde bestimmt:
(a) Bei Verwendung eines DGEBA-Harzes (z.B. Epikote 828) liegt der T_{g} bei 120 °C.
(b) Bei Verwendung eines epoxidierten Novolak-Harzes (z.B. Rütapox 0300) liegt der T_{g} bei 170 °C.

### Beispiel 2

Es wurde eine phosphorhaltige Komponente (a) der ringgeschlossenen Formel XXX verwendet, in der R³⁰ bis R³³ gleich Wasserstoff waren und R³⁴ Methyl war (s. Beispiel 1). Als Komponente (b) wurde 1-Methylimidazol (N-Methylimidazol) gewählt, und Komponente (c) ist Phenol.

Die Umsetzung der Komponenten (a), (b) und (c) kann in beliebiger Reihenfolge erfolgen und ergibt in allen Fällen 1-Methylimidazolium-(2-phenoxycarbonyl-ethyl)(methyl)phosphinat. Dieses erfindungsgemäße latente Ammoniumsalz ist bei Raumtemperatur flüssig. Eine Mischung von 10 Gew.-% latentes Ammoniumsalz und 90 Gew.-% Epoxidharz wurde hergestellt. Das Epoxidharzsystem ist, unabhängig vom Harztyp, bei Raumtemperatur lagerstabil und härtet auch bei 70 °C mehrere Stunden lang nicht.

Bei 125 °C erfolgt innerhalb von 15 Minuten eine komplette Härtung. Der Glasumwandlungspunkt T_{g} (DSC, Heizrate 10K/min) wurde bestimmt:
(a) Bei Verwendung eines DGEBA-Harzes (z.B. Epikote 828) liegt der T_{g} bei 118 °C.
(b) Bei Verwendung eines epoxidierten Novolak-Harzes (z.B. Rütapox 0300) liegt der T_{g} bei 190 °C.

### Beispiel 3

Es wurde eine phosphorhaltige Komponente (a) der ringgeschlossenen Formel XXX verwendet, in der R³⁰ bis R³³ gleich Wasserstoff waren und R³⁴ Methyl war (s. Beispiel 1). Als Komponente (b) wurde 1-Methylimidazol (N-Methylimidazol) gewählt, und Komponente (c) ist Ethylenglykol.

Die Umsetzung der Komponenten (a), (b) und (c) kann in beliebiger Reihenfolge erfolgen und ergibt in allen Fällen das Di-(1-Methylimidazolium)-Salz des durch die Dihydroxyverbindung Ethylenglykol verknüpften Bis-Phosphinats. Das latente Ammoniumsalz ist im Folgenden dargestellt:

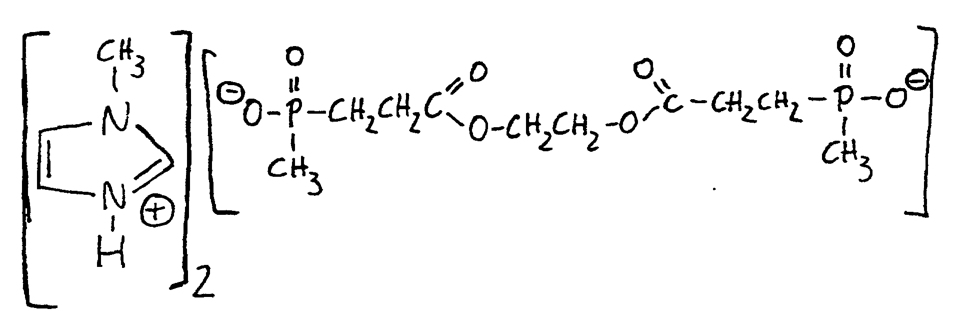

Dieses erfindungsgemäße latente Ammoniumsalz ist bei Raumtemperatur ebenfalls flüssig. Eine Mischung von 10 Gew.-% latentes Ammoniumsalz und 90 Gew.-% Epoxidharz wurde hergestellt. Das Epoxidharzsystem ist, unabhängig vom Harztyp, bei Raumtemperatur lagerstabil und härtet auch bei 70 °C mehrere Stunden lang nicht.

Bei 125 °C erfolgt innerhalb von 15 Minuten eine komplette Härtung. Der Glasumwandlungspunkt T_{g} (DSC, Heizrate 10K/min) wurde bestimmt:
(a) Bei Verwendung eines DGEBA-Harzes (z.B. Epikote 828) liegt der T_{g} bei 137 °C.
(b) Bei Verwendung eines epoxidierten Novolak-Harzes (z.B. Rütapox 0300) liegt der T_{g} bei 180 °C.

Im folgenden sind die Schemata 1 bis 3, auf die Bezug genommen wurde, dargestellt

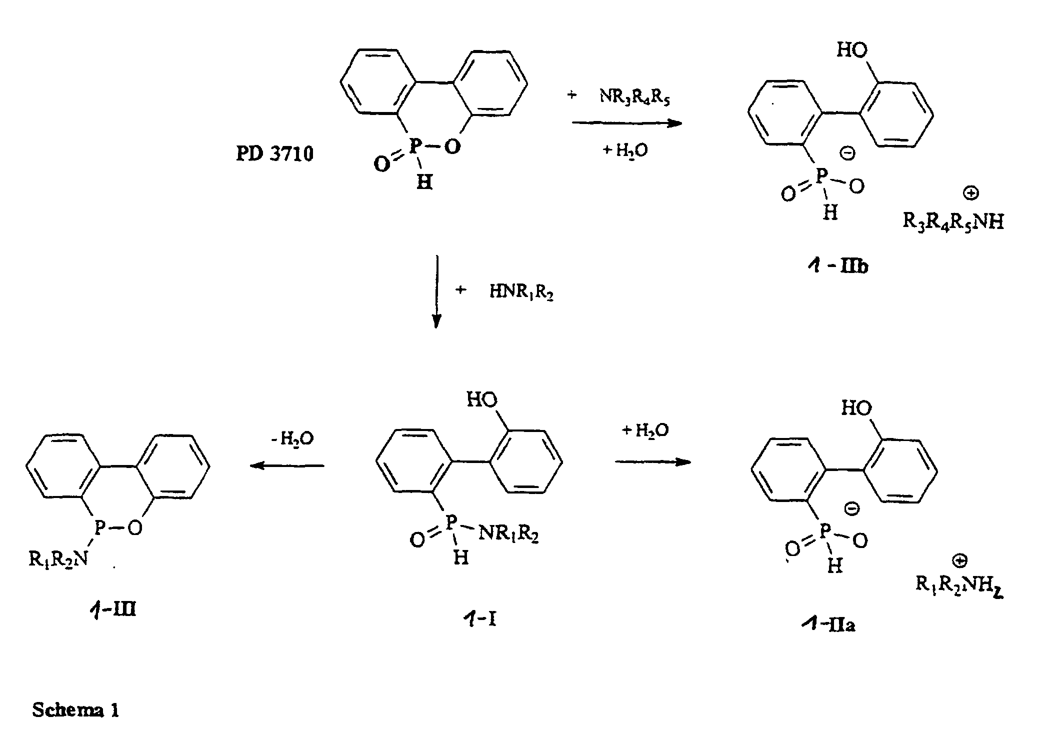

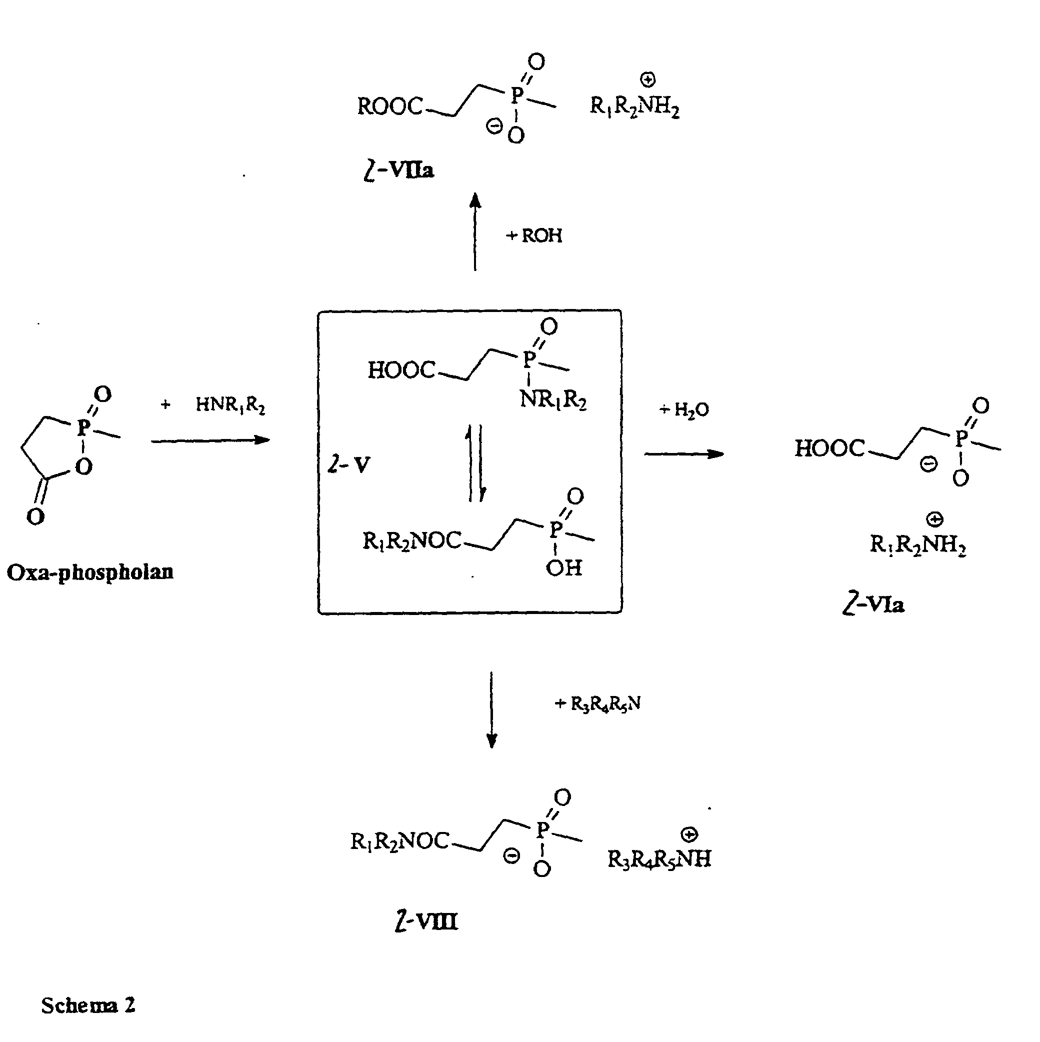

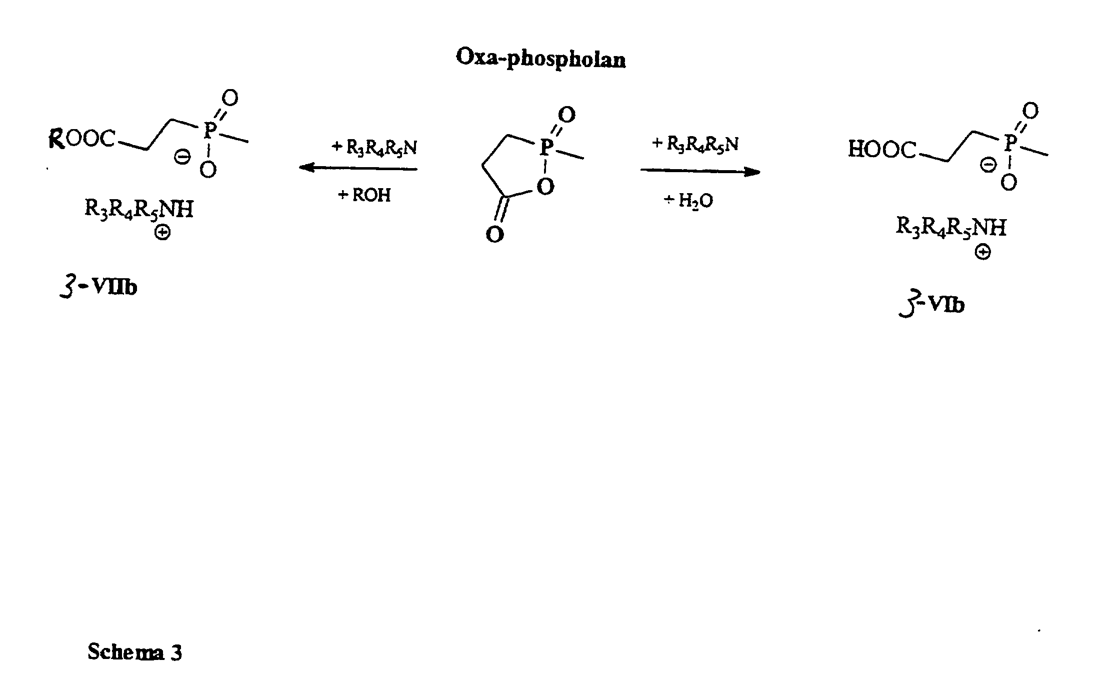

## Patentansprüche

1. Latente Kombinationsverbindung entsprechend Formel I 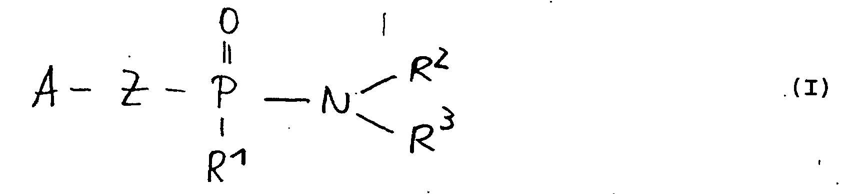 in der R¹ gleich einem allgemeinen Rest R⁰ ist, wobei
R⁰ Wasserstoff oder eine lineare oder verzweigte, gesättigte oder ungesättigte Kohlenwasserstoffgruppe mit 1 bis 100 Kohlenstoffatomen ist, die gegebenenfalls ein oder mehrere Heteroatome ausgewählt aus Sauerstoff, Stickstoff, Schwefel, Phosphor, Silicium und Halogen enthalten kann,
R² und R³ unabhängig voneinander die für R⁰ angegebene Bedeutung haben, wobei R² und R³ unter Ausbildung eines Zyklus oder mehrerer Zyklen verknüpft sein können,
A ausgewählt ist aus der Gruppe bestehend aus OH und COX, in der X ausgewählt ist aus der Gruppe bestehend aus OH, NH₂, NHR^{a}, NR^{b}R^{c} oder O⁻M⁺ ist, wobei R^{a} bis R^{c} unabhängig voneinander die für R⁰ angegebene Bedeutung haben, R^{b} und R^{c} unter Ausbildung eines Zyklus oder mehrerer Zyklen verknüpft sein können und M⁺ ein beliebiges Metallkation ist, und
Z eine zweiwertige lineare oder verzweigte, gesättigte oder ungesättigte Kohlenwasserstoffkette mit 2 bis 100 Kohlenstoffatomen bezeichnet, die gegebenenfalls ein oder mehrere Zyklen enthalten enthalten kann und gegebenenfalls ein oder mehrere Heteroatome ausgewählt aus Sauerstoff, Stickstoff, Schwefel, Phosphor, Silicium und Halogen enthalten kann.

2. Latente Kombinationsverbindung nach Anspruch 1, **dadurch gekennzeichnet, daß** R¹ verschieden von A-Z ist.

3. Latente Kombinationsverbindung nach Anspruch 1 oder 2, **dadurch gekennzeichnet, daß** R² nicht Wasserstoff ist.

4. Latente Kombinationsverbindung nach Anspruch 3, **dadurch gekennzeichnet, daß** R² und R³ nicht Wasserstoff sind.

5. Latente Kombinationsverbindung nach einem der vorhergehenden Ansprüche, **dadurch gekennzeichnet, daß** R¹ ausgewählt ist aus Wasserstoff, Methyl und Kohlenwasserstoffgruppen, die mindestens eine Epoxyfunktion aufweisen.

6. Latente Kombinationsverbindung nach einem der vorhergehenden Anspruche, **dadurch gekennzeichnet, daß** mindestens einer der Reste R² und R³ eine Kohlenwasserstoffgruppe ist, und diese Kohlenwasserstoffgruppe ausgewählt ist aus linearen oder verzweigten aliphatischen oder arylaliphatischen Kohlenwasserstoffgruppen.

7. Latente Kombinationsverbindung nach einem der vorhergehenden Ansprüche, **dadurch gekennzeichnet, daß** in NR²R³ die Gruppen R² und R³ verknüpft sind und abgeleitet sind von Imidäzöl, 2-Methylimidazol und 2-Ethyl-4-methylimidazol.

8. Latente Kombinationsverbindung nach einem der vorhergehenden Anspruche, **dadurch gekennzeichnet, daß** Z nicht durch Heteroatome in der Kohlenwasserstoffkette unterbrochen wird.

9. Latente Kombinationsverbindung nach Anspruch 8, **dadurch gekennzeichnet, daß** Z kein Heteroatom enthält.

10. Latente Kombinationsverbindung nach einem der vorhergehenden Ansprüche, **dadurch gekennzeichnet, daß**
a.) A gleich OH ist und
b.) Z in der Kette 4 Kohlenstoffatome hat.

11. Latente Kombinationsverbindung nach Anspruch 10, **dadurch gekennzeichnet, daß** Z ausgewählt ist aus Biphen-2,2'-diyl und Derivat von Biphen-2,2'-diyl.

12. Latente Kombinationsverbindung nach einem der Ansprüche 1 bis 9, **dadurch gekennzeichnet, daß**
a.) A gleich COOH,
b.) R¹ gleich Methyl oder Wasserstoff und
c.) Z gleich linear oder verzweigt ist und Alkan-(α,β)-diyl oder Arylalkan-(α,β)-diyl ist.

13. Latente Kombinationsverbindung nach Anspruch 12, **dadurch gekennzeichnet, daß**
b.) R¹ gleich Methyl ist.

14. Latente Kombinationsverbindung nach Anspruch 12 oder Anspruch 13, **dadurch gekennzeichnet, daß**
c.) Z gleich -CH₂CH₂-, ist.

15. Verfahren zur Herstellung eines latenten Ammoniumsalzes, **dadurch gekennzeichnet, daß** man mindestens eine latente Kombinationsverbindung nach einem der Ansprüche 1 bis 14 mit mindestens einem Reagenz umsetzt, welches Wasser umfaßt, wobei die in der Formel I in Anspruch 1 dargestellte P-N-Bindung hydrolytisch gespalten wird.

16. Verfahren zur Herstellung eines latenten Ammoniumsalzes, **dadurch gekennzeichnet, daß** man mindestens eine latente Kombinationsverbindung nach einem der Ansprüche 1 bis 9 und 12 bis 14, in der A gleich COOH ist, mit mindestens einem Reagenz umsetzt, welches mindestens eine Verbindung ausgewählt aus Wasser und ein- oder mehrwertigen Hydroxyverbindungen umfaßt, wobei die in Formel I in Anspruch 1 dargestellte P-N-Bindung hydrolytisch gespalten wird.

17. Verfahren nach Anspruch 16, **dadurch gekennzeichnet, daß** die Hydroxyverbindung ausgewählt ist aus ein- oder mehrwertigen Phenolen und ein- oder mehrwertigen Alkoholen.

18. Verfahren nach Anspruch 17, **dadurch gekennzeichnet, daß** die Hydroxyverbindung ausgewählt ist aus Phenol und ein- oder mehrwertigen aliphatischen Alkoholen.

19. Verfahren nach einem der Ansprüche 16 bis 18, **dadurch gekennzeichnet, daß** es die Veresterung der Gruppe A durch eine ein- oder mehrwertige Hydroxyverbindung einschließt.

20. Latentes Ammoniumsalz, erhältlich nach dem Verfahren nach einem der Ansprüche 15 bis 19.

21. Verfahren zur Herstellung einer latenten Kombinationsverbindung oder eines latenten Ammoniumsalzes, **dadurch gekennzeichnet, daß** man mindestens eine phosphorhaltige Komponente (a) ausgewählt aus
i) Derivaten des intramolekularen Esters der 4-Hydroxy-butan-1-phosphinsäure entsprechend einer der ringgeschlossenen Formeln X bis XV 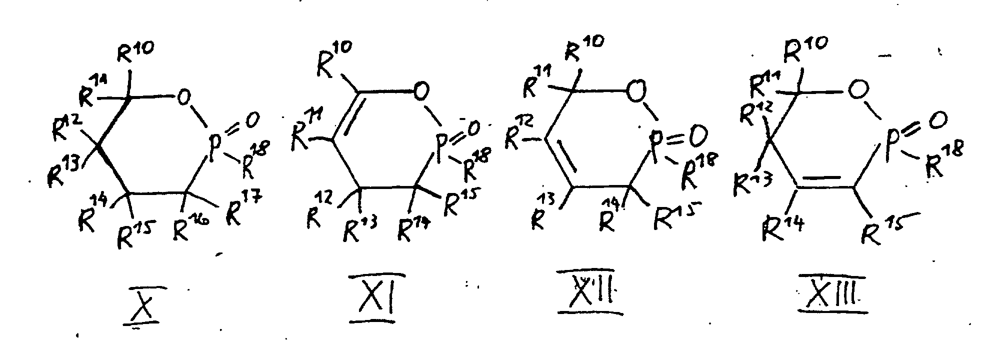 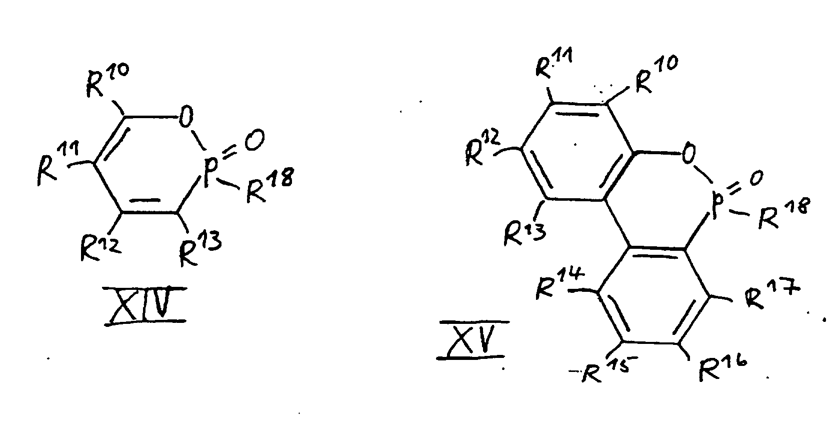 in denen R¹⁰ bis R¹⁸ unabhängig voneinander die für R⁰ in Anspruch 1 angegebene allgemei-ne Bedeutung haben, wobei zwei oder mehrere von R¹⁰ bis R¹⁷ unter Ausbildung eines Zyklus oder mehrerer Zyklen verknüpft sein können, und
ii) Derivaten des Phospholans entsprechend einer der ringgeschlossenen Formeln XXX und XXXI 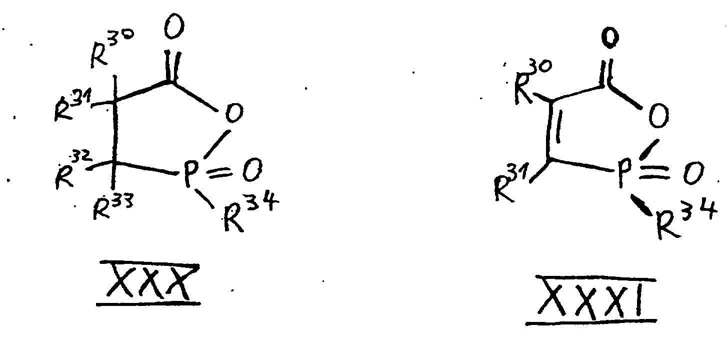 in denen R³⁰ bis R³⁴ unabhängig voneinander die für R⁰ in Anspruch 1 angegebene allgemeine Bedeutung haben und ein oder mehrere von R³⁰ bis R³³ unter Ausbildung eines Zyklus oder mehrerer Zyklen verknüpft sein können,
mit einer Komponente (b) umsetzt, die eine stickstoffhaltige Verbindung umfaßt, welche keine basische NH-Funktion hat, wobei das Verfahren die Umsetzung mit mindestens einer Komponente (c) ausgewählt aus Wasser und ein- oder mehrwertigen Hydroxyverbindungen umfaßt.

22. Verfahren zur Herstellung einer latenten Kombinationsverbindung oder eines latenten Ammoniumsalzes, **dadurch gekennzeichnet, daß** man mindestens eine phosphorhaltige Komponente (a) ausgewählt aus
i) Derivaten des intramolekularen Esters der 4-Hydroxy-butan-1-phosphinsäure entsprechend einer der ringgeschlossenen Formeln X bis XV 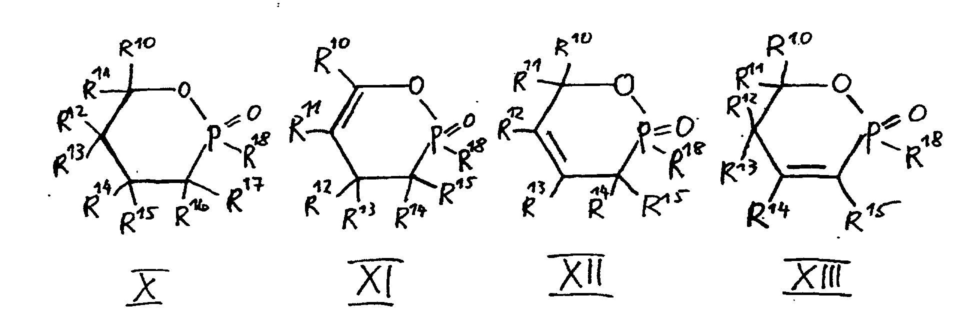 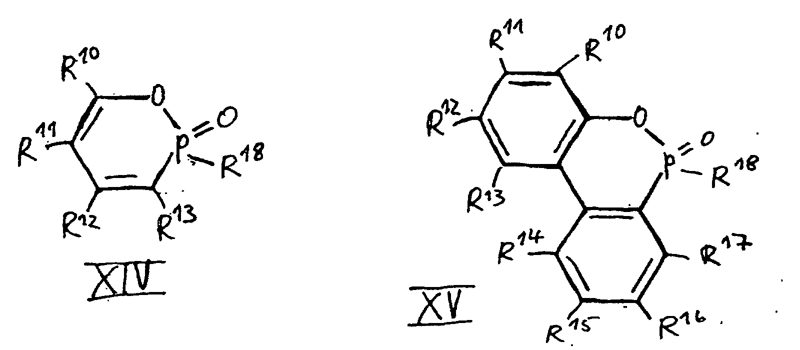 in denen R¹⁰ bis R¹⁸ unabhängig voneinander die für R⁰ in Anspruch 1 angegebene allgemeine Bedeutung haben, wobei zwei oder mehrere von R¹⁰ bis R¹⁷ unter Ausbildung eines Zyklus oder mehrerer Zyklen verknüpft sein können, und
ii) Derivaten des Phospholans entsprechend einer der ringgeschlossenen Formeln XXX und XXXI 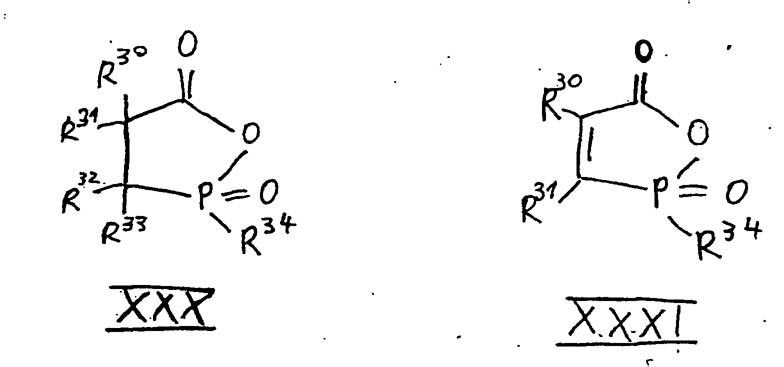 in denen R³⁰ bis R³⁴ unabhängig voneinander die für R⁰ in Patentanspruch 1 angegebene allgemeine Bedeutung haben und ein oder mehrere von R³⁰ bis R³³ unter Ausbildung eines Zyklus oder mehrerer Zyklen verknüpft sein können,
mit einer Komponente (b) umsetzt, die eine stickstoffhaltige Verbindung umfaßt, welche mindestens eine basische NH-Funktion hat.

23. Verfahren zur Herstellung einer latenten Kombinationsverbindung oder eines latenten Ammoniumsalzes, **dadurch gekennzeichnet, daß** man mindestens eine phosphorhaltige Komponente (a) ausgewählt aus
i) Derivaten der 4-Hydroxy-butan-1-phosphinsäure entsprechend einer der ringoffenen Formeln XVI bis XXI 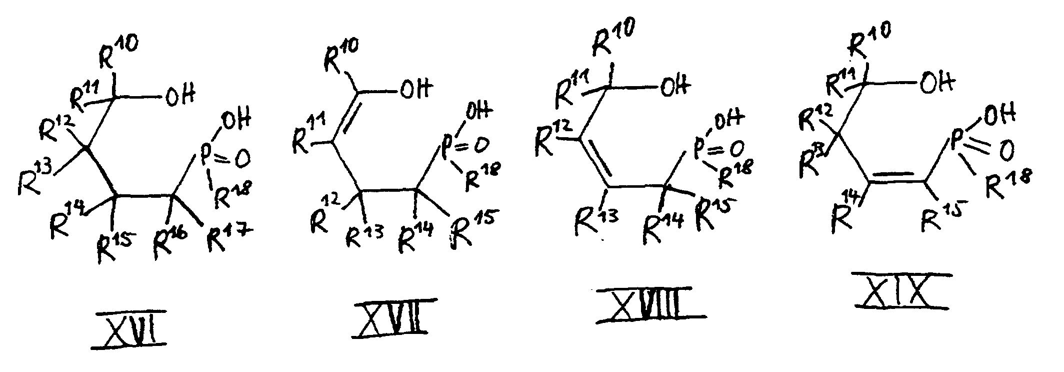 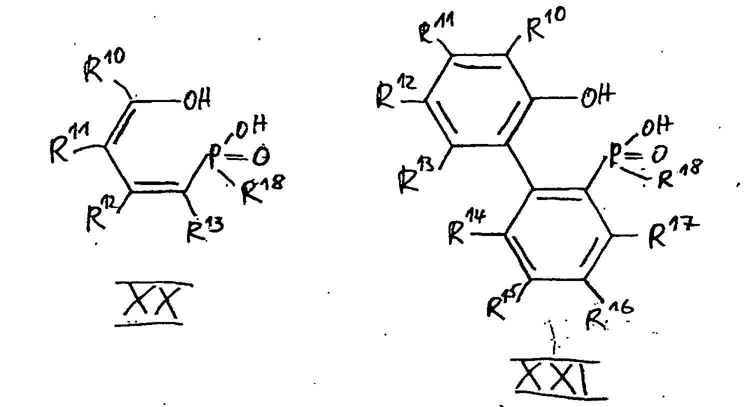 in denen R¹⁰ bis R¹⁸ unabhängig voneinander die für R⁰ in Anspruch 1 angegebene allgemeine Bedeutung haben, wobei zwei oder mehrere von R¹⁰ bis R¹⁷ unter Ausbildung eines Zyklus oder mehrerer Zyklen verknüpft sein können, und
ii) Derivaten des Phospholans entsprechend einer der ringoffenen Formeln XXXII und XXXIII 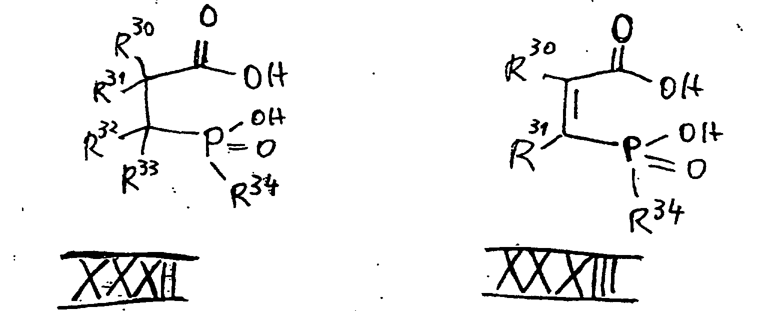 in denen R³⁰ bis R³⁴ unabhängig voneinander die für R⁰ in Anspruch 1 angegebene allgemei-ne Bedeutung haben und ein oder mehrere von R³⁰ bis R³³ unter Ausbildung eines Zyklus oder mehrerer Zyklen verknüpft sein können,
mit einer Komponente (b) umsetzt, die eine stickstoffhaltige Verbindung umfaßt.

24. Verfahren nach einem der Anspruche 21 bis 23, **dadurch gekennzeichnet, daß** R¹⁰ bis R¹⁷ und R³⁰ bis R³³ unabhängig voneinander ausgewählt sind aus Wasserstoff und linearen oder verzweigten aliphatischen Kohlenwasserstoffgruppen.

25. Verfahren nach Anspruch 24, **dadurch gekennzeichnet, daß** R¹⁰ bis R¹⁷ und R³⁰ bis R³³ alle Wasserstoff sind.

26. Verfahren nach einem der Ansprüche 21 bis 25, **dadurch gekennzeichnet, daß** R¹⁸ und R³⁴ unabhängig voneinander ausgewählt sind aus der Gruppe bestehend aus Wasserstoff, Methyl und Kohlenwasserstoffgruppen, die mindestens eine Epoxyfunktion aufweisen.

27. Verfahren nach einem der Ansprüche 21 bis 26, **dadurch gekennzeichnet, daß** im Phospholan der Formeln XXX bis XXXIII R³⁰ bis R³³ Wasserstoff sind und R³⁴ Methyl ist.

28. Verfahren nach einem der Ansprüche 22 bis 27, **dadurch gekennzeichnet, daß** es die Umsetzung mit mindestens einem Reagenz ausgewählt aus Wasser und ein- oder mehrwertigen Hydroxyverbindungen umfaßt.

29. Verfahren nach Anspruch 21 oder 28, **dadurch gekennzeichnet, daß** die ein- oder mehrwertige Hydroxyverbindung ausgewählt ist aus ein- oder mehrwertigen Phenolen und ein- oder mehrwertigen Alkoholen.

30. Verfahren nach Anspruch 29, **dadurch gekennzeichnet, daß** die Hydroxyverbindung ausgewählt ist aus Phenol und aliphatischen ein- oder mehrwertigen Alkoholen.

31. Verfahren nach einem der Ansprüche 22 bis 29, **dadurch gekennzeichnet, daß** die stickstoffhaltige Verbindung ausgewählt ist aus der Gruppe bestehend aus Imidazol, 2-Methylimidazol und 2-Ethyl-4-methylimidazol sowie deren Salzen.

32. Verfahren nach einem der Ansprüche 21 und 23 bis 30, **dadurch gekennzeichnet, daß** die stickstoffhaltige Verbindung ausgewählt ist aus der Gruppe bestehend aus Tetramethylethylendiamin, Dimethyloctylamin, Dimethylaminoethanol, Dimethylbenzylamin, 2,4,6-Tris(dimethylaminomethyl) -phenol, N,N'-Tetramethyldiaminodiphenylmethan, N,N'-Dimethylpiperazin, N-Methylmorpholin, N-Methylpiperidin, N-Ethylpyrrolidin, 1,4-Diazabicyclo[2.2.2]-octan, Chinolinen, 1-Methylimidazol, 1,2-Dimethylimidazol, 1,2,4,5-Tetramethylimidazol, 1-Cyanoethyl-2-phenylimidazol und 1- (4,6-Diamino-s-triazinyl-2-ethyl-)-2-phenylimidazol sowie deren Salzen.

33. Verwendung der latenten Kombinationsverbindung oder des latenten Ammoniumsalzes gemäß einem der Ansprüche 1 bis 14 und 20 oder erhalten gemäß dem Verfahren eines der Ansprüche 21 bis 32 in einem Einkomponentenepoxidharzsystem.

34. Verwendung nach Anspruch 33, **dadurch gekennzeichnet, daß** das Einkomponentenepoxidharzsystem ein Einkomponentenepoxidharz-Klebstoff ist.

35. Einkomponentenepoxidharzsystem, **dadurch gekennzeichnet, daß** es mindestens eine Epoxidharzkomponente und mindestens eine Härter/Beschleuniger-Komponente ausgewählt aus den latenten Kombinationsverbindungen und den latenten Ammoniumsalzen gemäß einem der Ansprüche 1 bis 14 und 20 oder erhalten gemäß dem Verfahren eines der Ansprüche 21 bis 32 umfaßt.

36. Einkomponentenepoxidharz-Klebstoff, **dadurch gekennzeichnet, daß** er mindestens eine Epoxidharzkomponente und mindestens eine Härter/Beschleuniger-Komponente ausgewählt aus den latenten Kombinationsverbindungen und den latenten Ammoniumsalzen gemäß einem der Ansprüche 1 bis 14 und 20 oder erhalten gemäß dem Verfahren eines der Ansprüche 21 bis 32 umfaßt.

37. Verfahren zur Herstellung von Formkörpern, Überzügen und Verklebungen mit flammhemmenden Eigenschaften, **dadurch gekennzeichnet, daß** es die Verwendung eines Einkomponentenepoxidharzsystems nach Anspruch 35 oder eines Einkomponentenepoxidharz-Klebstoffs nach Anspruch 36 und einen Härtungsschritt umfaßt.

38. Formkörper, Überzüge und Verklebungen mit flammhemmenden Eigenschaften, **dadurch gekennzeichnet, daß** sie durch Härtung aus einem Einkomponentenepoxidharzsystem nach Anspruch 35 oder einem Einkomponentenepoxidharz-Klebstoff nach Anspruch 36 erhältlich sind.

39. Harzinjektionsverfahren für faserverstärkte Verbundwerkstoffe mit flammhemmenden Eigenschaften, **dadurch gekennzeichnet, daß** es umfaßt
a.) Imprägnieren eines anorganischen oder organischen Verstärkungsmaterials in Form von Fasern, eines Vlieses, Gewebes oder Flächenstoffes mit einem Einkomponentenepoxidharzsystem nach Anspruch 35 und
b.) Härten des imprägnierten Verstärkungsmaterials bei einer Temperatur zwischen 70 °C und 160 °C

40. Verfahren nach Anspruch 39, **dadurch gekennzeichnet, daß** das Härten bei einer Temperatur zwischen 90°C und 140°C stattfindet.

41. Prepregs, **dadurch gekennzeichnet, daß** sie ein anorganisches oder organisches Verstärkungsmaterial in Form von Fasern, eines Vlieses, Gewebes oder Flächenstoffes, welches mit einem Einkomponentenepoxidharzsystem nach Anspruch 35 imprägniert ist, umfassen.

42. Verfahren zur Herstellung von faserverstärkten Verbundwerkstoffen mit flammhemmenden Eigenschaften, **dadurch gekennzeichnet, daß** es die Härtung eines Prepregs nach Anspruch 41 bei einer Temperatur zwischen 70°C und 160°C umfaßt.

43. Verfahren nach Anspruch 42, **dadurch gekennzeichnet, daß** die Härtung bei einer Temperatur zwischen 90°C und 140°C stattfindet.

44. Faserverstärkter Verbundwerkstoff mit flammhemmenden Eigenschaften, **dadurch gekennzeichnet, daß** er die gehärtete Form eines Prepregs nach Anspruch 41 ist.

45. Leiterplatten aus Prepregs, **dadurch gekennzeichnet, daß** ihr Aufbau mindestens einen Verbundwerkstoff nach Anspruch 44 umfaßt.

## Claims

1. Latent combination compound according to formula I 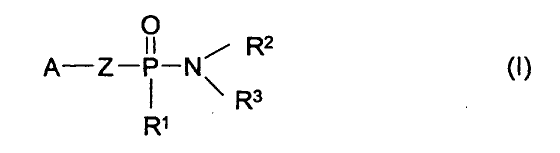 in which R¹ is equal to a general radical R⁰, wherein
R⁰ is hydrogen or a linear or branched, saturated or unsaturated hydrocarbon group with 1 to 100 carbon atoms, which can optionally contain one or more heteroatoms selected from oxygen, nitrogen, sulfur, phosphorus, silicon and halogen,
R² and R³, independently of each other, have the meaning given for R⁰, and R² and R³ can be connected through the formation of a ring or several rings,
A is selected from the group consisting of OH and COX, where X is selected from the group consisting of OH, NH₂, NHR^{a}, NR^{b}R^{c} or O⁻ M⁺, in which R^{a} to R^{c}, independently of each other, have the meaning given for R⁰, and R^{b} and R^{c} can be connected through the formation of a ring or several rings and M⁺ is any metal ion, and
Z denotes a divalent linear or branched, saturated or unsaturated hydrocarbon chain with 2 to 100 carbon atoms, which can optionally comprise one or several rings and can optionally comprise one or more heteroatoms selected from oxygen, nitrogen, sulfur, phosphorus, silicon and halogen.

2. Latent combination compound according to Claim 1, **characterised in that** R¹ is different from A - Z.

3. Latent combination compound according to Claim 1 or 2, **characterised in that** R² is not hydrogen.

4. Latent combination compound according to Claim 3, **characterised in that** R² and R³ are not hydrogen.

5. Latent combination compound according to any one of the preceding Claims, **characterised in that** R¹ is selected from hydrogen, methyl and hydrocarbon groups that comprise at least one epoxy function.

6. Latent combination compound according to one of the preceding Claims, **characterised in that** at least one of the radicals R² and R³ is a hydrocarbon group and this hydrocarbon group is selected from linear or branched aliphatic or arylaliphatic hydrocarbon groups.

7. Latent combination compound according to one of the preceding Claims, **characterised in that** in NR²R³, the R² and R³ groups are connected and are derived from imidazole, 2-methyl imidazole and 2-ethyl-4-methylimidazole.

8. Latent combination compound according to one of the preceding Claims, **characterised in that** Z is not interrupted by heteroatoms in the hydrocarbon chain.

9. Latent combination compound according to Claim 8, **characterised in that** Z does not comprise a heteroatom.

10. Latent combination compound according to one of the preceding Claims, **characterised in that**
a.) A is equal to OH and
b.) Z has 4 carbon atoms in the chain.

11. Latent combination compound according to Claim 10, **characterised in that** Z is selected from biphenyl-2,2'-diyl and derivatives of biphenyl-2,2'-diyl.

12. Latent combination compound according to one of Claims 1 to 9, **characterised in that**
a.) A equals COOH,
b.) R¹ equals methyl or hydrogen and
c.) Z is a linear or branched alkane-(α,β)-diyl or arylalkane-(α,β)-diyl.

13. Latent combination compound according to Claim 12, **characterised in that**
b.) R¹ is equal to methyl.

14. Latent combination compound according to Claim 12 or Claim 13, **characterised in that**
c.) Z is equal to - CH₂CH₂-.

15. Process for preparing a latent ammonium salt, **characterised in that** at least one latent combination compound according to one of Claims 1 to 14 is reacted with at least one reagent which includes water, such that the P-N bond shown in Formula I in Claim 1 is hydrolytically cleaved.

16. Process for preparing a latent ammonium salt, **characterised in that** at least one latent combination compound according to one of Claims 1 to 9 and 12 to 14, in which A equals COOH, is reacted with at least one reagent which includes at least one compound selected from water and mono- or polyhydric hydroxy compounds, such that the P-N bond shown in Formula I in Claim 1 is hydrolytically cleaved.

17. Process according to Claim 16, **characterised in that** the hydroxy compound is selected from mono- or polyhydric phenols and mono- or polyhydric alcohols.

18. Process according to Claim 17, **characterised in that** the hydroxy compound is selected from phenol and mono- or polyhydric aliphatic alcohols.

19. Process according to one of Claims 16 to 18, **characterised in that** it involves the esterification of the group A by a mono- or polyhydric hydroxy compound.

20. Latent ammonium salt, obtainable by the process according to one of Claims 15 to 19.

21. Process for preparing a latent combination compound or a latent ammonium salt, **characterised in that** at least one phosphorus-containing component (a) selected from
i) derivatives of the intramolecular ester of 4-hydroxy-butane-1 phosphinic acid according to one of the ring-closed formulae X to XV 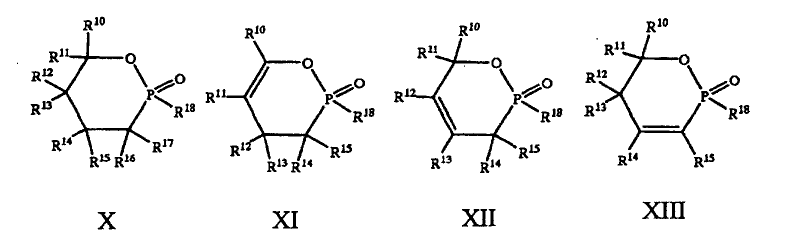 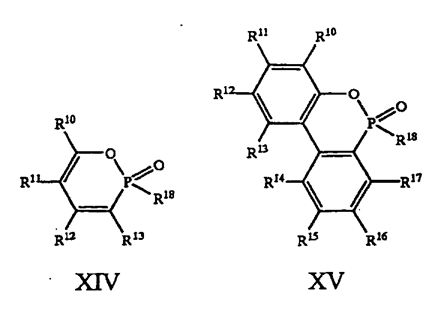 in which R¹⁰ to R¹⁸, independently of each other, have the general meaning given for R⁰ in Claim 1, two or more of R¹⁰ to R¹⁷ being able to be connected through the formation of a ring or several rings, and
ii) derivatives of phospholane according to one of the ring-closed formulae XXX and XXXI 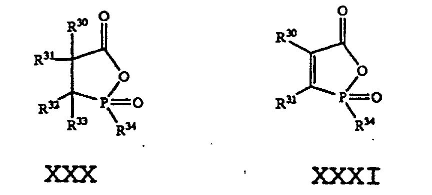 in which R³⁰ to R³⁴, independently of each other, have the general meaning given for R⁰ in Claim 1 and one or more of R³⁰ to R³³ are able to be connected through the formation of a ring or several rings,
is reacted with a component (b) that includes a nitrogen-containing compound which has no basic NH function, the process comprising the reaction with at least one component (c) selected from water and mono- or polyhydric hydroxy compounds.

22. Process for preparing a latent combination compound or a latent ammonium salt, **characterised in that** at least one phosphorus-containing component (a) selected from
i) derivatives of the intramolecular ester of 4-hydroxy-butane-1 phosphinic acid according to one of the ring-closed formulae X to XV 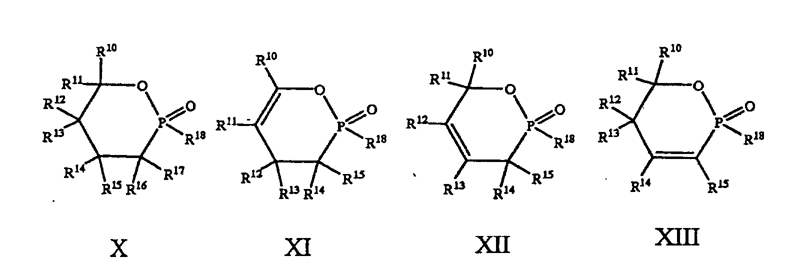 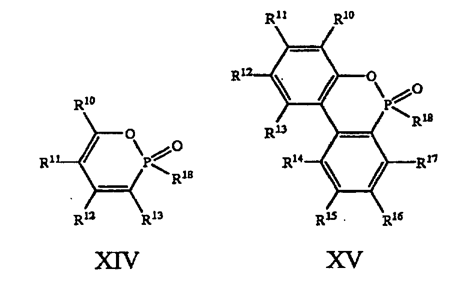 in which R¹⁰ to R¹⁸, independently of each other, have the general meaning given for R⁰ in Claim 1, two or more of R¹⁰ to R¹⁷ being able to be connected through the formation of a ring or several rings, and
ii) derivatives of phospholane according to one of the ring-closed formulae XXX and XXXI 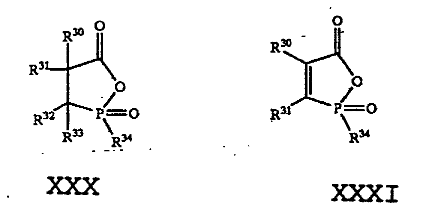 in which R³⁰ to R³⁴, independently of each other, have the general meaning given for R⁰ in Claim 1 and one or more of R³⁰ to R³³ are able to be connected through the formation of a ring or several rings,
is reacted with a component (b) that includes a nitrogen-containing compound that has at least one basic NH function.

23. Process for preparing a latent combination compound or a latent ammonium salt, **characterised in that** at least one phosphorus-containing component (a) selected from
i) derivatives of the 4-hydroxy-butane-1 phosphinic acid according to one of the ring-opened formulae XVI to XXI 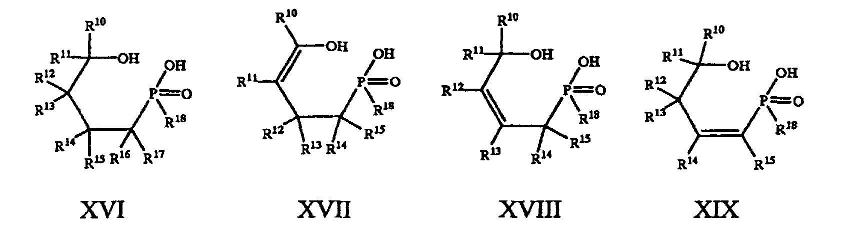 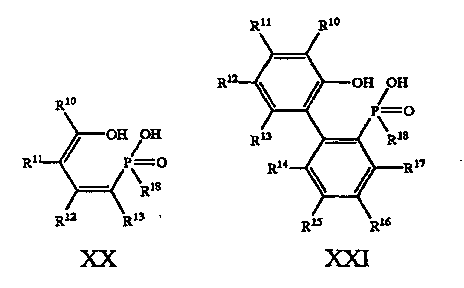 in which R¹⁰ to R¹⁸, independently of each other, have the general meaning given for R⁰ in Claim 1, two or more of R¹⁰ to R¹⁷ being able to be connected through the formation of a ring or several rings, and
ii) derivatives of phospholane according to one of the ring-opened formulae XXXII and XXXIII 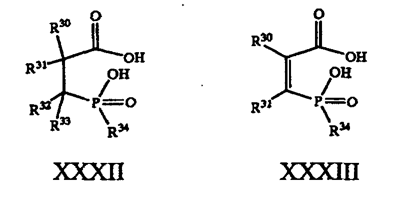 in which R³⁰ to R³⁴, independently of each other, have the general meaning given for R⁰ in Claim 1 and one or more of R³⁰ to R³³ are able to be connected through the formation of a ring or several rings,
is reacted with a component (b) that includes a nitrogen-containing compound.

24. Process according to one of Claims 21 to 23, **characterised in that** R¹⁰ to R¹⁷ and R³⁰ to R³³, independently of each other, are selected from hydrogen and linear or branched aliphatic hydrocarbon groups.

25. Process according to Claim 24, **characterised in that** R¹⁰ to R¹⁷ and R³⁰ to R³³ are all hydrogen.

26. Process according to one of Claims 21 to 25, **characterised in that** R¹⁸ and R³⁴, independently of each other, are selected from the group consisting of hydrogen, methyl and hydrocarbon groups which have at least one epoxy function.

27. Process according to one of Claims 21 to 26, **characterized in that** R³⁰ to R³³ are hydrogen and R³⁴ is methyl in the phospholane of the formulae XXX to XXXIII.

28. Process according to one of Claims 22 to 27, **characterised in that** it includes the reaction with at least one reagent selected from water and mono- or polyhydric hydroxy compounds.

29. Process according to Claim 21 or 28, **characterised in that** the mono- or polyhydric hydroxy compound is selected from mono- or polyhydric phenols and mono- or polyhydric alcohols.

30. Process according to Claim 29, **characterised in that** the hydroxyl compound is selected from phenol and aliphatic mono- or polyhydric alcohols.

31. Process according to one of Claims 22 to 29, **characterised in that** the nitrogen-containing compound is selected from the group consisting of imidazole, 2-methylimidazole and 2-ethyl-4-methylimidazole as well as their salts.

32. Process according to one of Claims 21 and 23 to 30, **characterised in that** the nitrogen-containing compound is selected from the group consisting of tetramethylethylenediamine, dimethyloctylamine, dimethylaminoethanol, dimethylbenzylamine, 2,4,6-tris(dimethylaminomethyl)-phenol, N,N'-tetramethyldiaminodiphenylmethane, N,N'-dimethylpiperazine, N-methylmorpholine, N-methylpiperidine, N-ethylpyrrolidine, 1,4-diazabicyclo[2.2.2]-octane, quinolines, 1-methylimidazole, 1,2-dimethylimidazole, 1,2,4,5-tetramethylimidazole, 1-cyanoethyl-2-phenylimidazole and 1-(4,6-diamino-s-triazinyl-2-ethyl-)-2-phenylimidazole as well as their salts.

33. Use of the latent combination compound or latent ammonium salt according to one of Claims 1 to 14 and 20 or obtained according to the process of one of the Claims 21 to 32 in a one-component epoxy resin system.

34. Use according to Claim 33, **characterised in that** the one-component epoxy resin system is a one-component epoxy resin adhesive.

35. One-component epoxy resin system, **characterised in that** it includes at least one epoxy resin component and at least one curing agent/accelerator component selected from the latent combination compounds and the latent ammonium salts according to one of Claims 1 to 14 and 20, or obtained according to the process of one of Claims 21 to 32.

36. One-component epoxy resin adhesive, **characterised in that** it includes at least one epoxy resin component and at least one curing agent/accelerator component selected from the latent combination compounds and the latent ammonium salts according to one of Claims 1 to 14 and 20, or obtained according to the process of one of Claims 21 to 32.

37. Process for preparing moulded articles, coatings and closures with flame-retardant properties, **characterised in that** it includes the use of a one-component epoxy resin system according to Claim 35 or a one-component epoxy resin adhesive according to Claim 36 and a curing step.

38. Moulded bodies, coatings and closures with flame-retardant properties, **characterised in that** they are obtained by curing a one-component epoxy resin system according to Claim 35 or a one-component epoxy resin adhesive according to Claim 36.

39. Resin-injection process for fibre-reinforced composite materials with flame-retardant properties, **characterised in that** it includes
a.) impregnating an inorganic or organic reinforcing material in the form of fibres, a fleece, fabric or flat material with a one-component epoxy resin system according to Claim 35 and
b.) curing the impregnated reinforcing material at a temperature between 70°C and 160°C.

40. Process according to Claim 39, **characterised in that** the curing takes place at a temperature between 90°C and 140°C.

41. Prepregs, **characterised in that** they include an inorganic or organic reinforcing material in the form of fibres, a fleece, fabric or flat material that is impregnated with a one-component epoxy resin system according to Claim 35.

42. Process for preparing fibre-reinforced composite materials with flame-retardant properties, **characterised in that** it comprises curing a prepreg according to Claim 41 at a temperature between 70°C and 160°C.

43. Process according to Claim 42, **characterised in that** curing takes place at a temperature between 90°C and 140°C.

44. Fibre-reinforced composite material with flame-retardant properties, **characterised in that** it is the cured form of a prepreg according to Claim 41.

45. Printed circuit boards made from prepregs, **characterised in that** their structure includes at least one composite material according to Claim 44.

## Revendications

1. Composé de combinaison latent répondant à la formule I 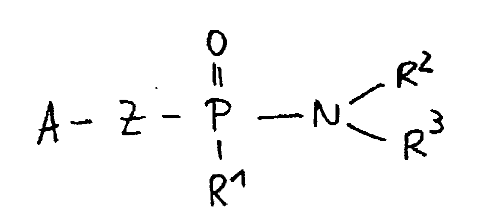 dans laquelle R¹ est un reste général R⁰, où
R⁰ est un hydrogène ou un groupement hydrocarboné saturé ou insaturé, linéaire ou ramifié, ayant de 1 à 100 atomes de carbone, qui peut éventuellement contenir un ou plusieurs hétéroatomes choisis parmi l'oxygène, l'azote, le soufre, le phosphore, le silicium et les halogènes,
R² et R³, indépendants l'un de l'autre, ont la signification donnée pour R⁰, dans laquelle R² et R³ peuvent être reliés pour former un ou plusieurs cycles,
A est choisi dans le groupe constitué de OH et COX, où X est choisi dans le groupe constitué de OH, NH₂, NHR^{a}, NR^{b}R^{c} ou bien est O⁻M⁺, où R^{a} à R^{c}, indépendants les uns des autres, ont la signification donnée pour R⁰, où R^{b} et R^{c} peuvent être reliés pour former un ou plusieurs cycles, et où M⁺ est un cation métallique quelconque, et
Z est une chaîne hydrocarbonée divalente, linéaire ou ramifiée, saturée ou insaturée, ayant de 2 à 100 atomes de carbone, qui peut éventuellement contenir un ou plusieurs cycles et peut éventuellement contenir un ou plusieurs hétéroatomes choisis parmi l'oxygène, l'azote, le soufre, le phosphore, le silicium et les halogènes.

2. Composé de combinaison latent selon la revendication 1, **caractérisé en ce que** R¹ est différent de A-Z.

3. Composé de combinaison latent selon la revendication 1 ou 2, **caractérisé en ce que** R² n'est pas un hydrogène.

4. Composé de combinaison latent selon la revendication 3, **caractérisé en ce que** ni R² et ni R³ ne sont des hydrogènes.

5. Composé de combinaison latent selon l'une des revendications précédentes, **caractérisé en ce que** R¹ est choisi parmi l'hydrogène, le méthyle et les groupements hydrocarbonés qui présentent au moins une fonction époxy.

6. Composé de combinaison latent selon l'une des revendications précédentes, **caractérisé en ce qu'**au moins l'un des restes R² et R³ est un groupement hydrocarboné, et **en ce que** ce groupement hydrocarboné est choisi parmi les groupements hydrocarbonés linéaires ou ramifiés, aliphatiques ou arylaliphatiques.

7. Composé de combinaison latent selon l'une des revendications précédentes, **caractérisé en ce que**, dans NR²R³, les groupements R² et R³ sont reliés et dérivent de l'imidazole, du 2-méthylimidazole et du 2-éthyl-4-méthylimidazole.

8. Composé de combinaison latent selon l'une des revendications précédentes, **caractérisé en ce que** Z n'est pas interrompu par des hétéroatomes dans la chaîne hydrocarbonée.

9. Composé de combinaison latent selon la revendication 8, **caractérisé en ce que** Z ne contient pas d'hétéroatome.

10. Composé de combinaison latent selon l'une des revendications précédentes, **caractérisé en ce que**
a) A est égal à OH et
b) Z comporte, dans la chaîne, 4 atomes de carbone.

11. Composé de combinaison latent selon la revendication 10, **caractérisé en ce que** Z est choisi parmi un biphén-2,2'-diyle et un dérivé de biphén-2,2'-diyle.

12. Composé de combinaison latent selon l'une des revendications 1 à 9, **caractérisé en ce que**
a) A est COOH
b) R¹ est un méthyle ou un hydrogène et
c) Z est linéaire ou ramifié, et est un alcan-(α,β)-diyle ou un arylalcan-(α,β)-diyle.

13. Composé de combinaison latent selon la revendication 12, **caractérisé en ce que**
b) R¹ est un méthyle.

14. Composé de combinaison latent selon la revendication 12 ou la revendication 13, **caractérisé en ce que**
c) Z est -CH₂CH₂-.

15. Procédé de préparation d'un sel d'ammonium latent, **caractérisé en ce qu'**on fait réagir au moins un composé de combinaison latent selon l'une des revendications 1 à 4 avec au moins un réactif, lequel contient de l'eau, dans lequel la liaison P-N représentée dans la formule I de la revendication 1 est rompue par hydrolyse.

16. Procédé de préparation d'un sel d'ammonium latent, **caractérisé en ce qu'**on fait réagir au moins un composé de combinaison latent selon l'une des revendications 1 à 9 et 12 à 14, dans laquelle A est égal à COOH, avec au moins un réactif, lequel comprend au moins un composé choisi parmi l'eau et un composé hydroxylé mono ou polyvalent, dans lequel la liaison P-N représentée dans la formule I de la revendication 1 est rompue par hydrolyse.

17. Procédé selon la revendication 16, **caractérisé en ce que** le composé hydroxylé est choisi parmi les phénols mono ou polyvalents et les alcools mono ou polyvalents.

18. Procédé selon la revendication 17, **caractérisé en ce que** le composé hydroxylé est choisi parmi le phénol et les alcools mono ou polyvalents aliphatiques.

19. Procédé selon l'une des revendications 16 à 18, **caractérisé en ce qu'**il comprend l'estérification du groupement A par un composé hydroxylé mono ou polyvalent.

20. Sel d'ammonium latent, susceptible d'être obtenu par le procédé selon l'une des revendications 15 à 19.

21. Procédé de préparation d'un composé de combinaison latent ou d'un sel d'ammonium latent, **caractérisé en ce qu'**on fait réagir au moins un composant contenant du phosphore (a) choisi parmi
i) les dérivés de l'ester intramoléculaire de l'acide 4-hydroxy-butan-1-phosphinique répondant à l'une des formules à cycle fermé X à XV suivantes : 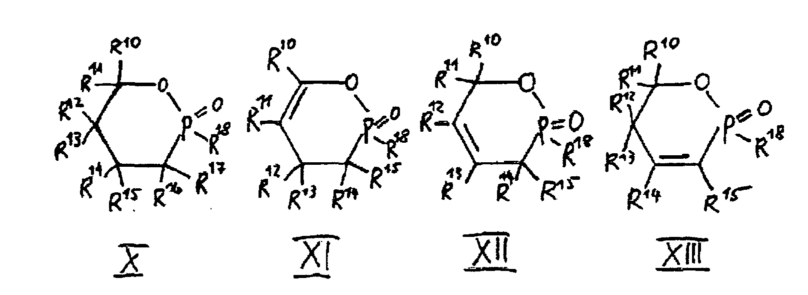 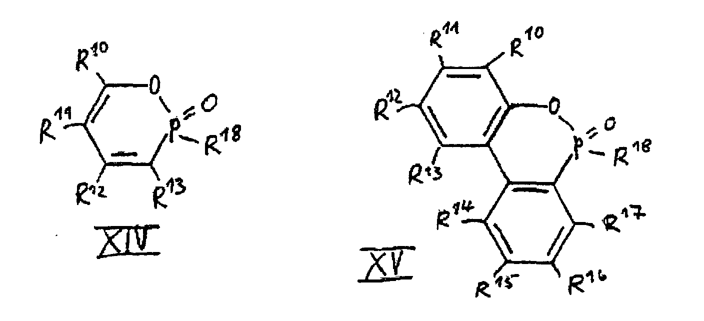 dans lesquelles les groupes R¹⁰ à R¹⁸ ont, indépendants les uns des autres, la signification générale donnée pour R⁰ dans la revendication 1, dans lequel deux ou plusieurs des R¹⁰ à R¹⁷ pouvant être reliés pour former un ou plusieurs cycles, et
ii) les dérivés du phospholane répondant à l'une des formules à cycle fermé XXX et XXXI suivantes : 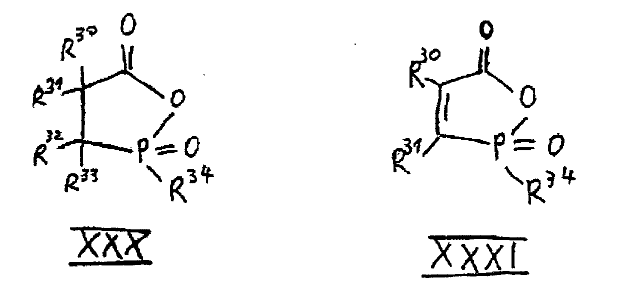 dans lesquelles les groupes R³⁰ à R³⁴ont, indépendants les uns des autres, la signification générale donnée pour R⁰ dans la revendication 1, et où un ou plusieurs des R³⁰ à R³³ peuvent être reliés pour former un ou plusieurs cycles,
avec un composant (b) qui comprend un composé contenant de l'azote, lequel ne comporte pas de fonction NH basique, le procédé comprenant la réaction avec au moins un composant (c) choisi parmi l'eau et un composé hydroxylé mono ou polyvalent.

22. Procédé de préparation d'un composé de combinaison latent ou d'un sel d'ammonium latent, **caractérisé en ce qu'**on fait réagir au moins un composant contenant du phosphore (a) choisi parmi
i) les dérivés de l'ester intramoléculaire de l'acide 4-hydroxy-butane-1-phosphinique répondant à l'une des formules à cycle fermé X à XV suivantes : 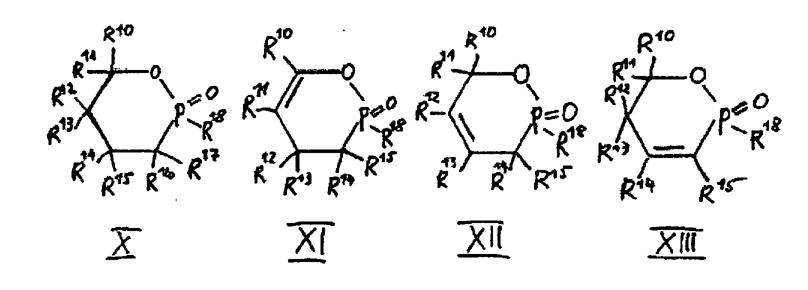 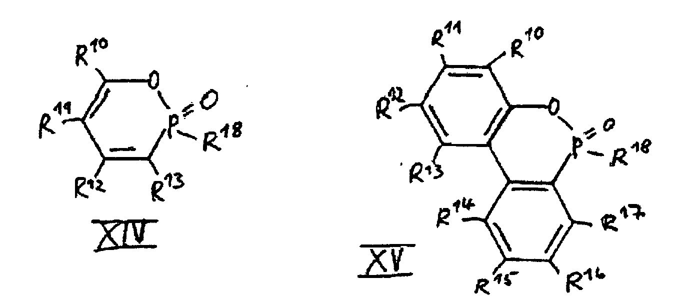 dans lesquelles les groupes R¹⁰ à R¹⁸ ont, indépendants les uns des autres, la signification générale donnée pour R⁰ dans la revendication 1, deux ou plusieurs des R¹⁰ à R¹⁷ pouvant être reliés pour former un ou plusieurs cycles et
ii) les dérivés du phospholane répondant à l'une des formules à cycle fermé XXX et XXXI suivantes : 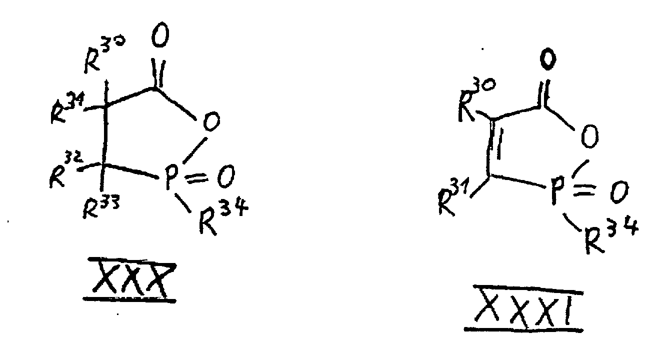 dans lesquelles les groupes R³⁰ à R³⁴ ont, indépendants les uns des autres, la signification générale donnée pour R⁰ dans la revendication 1, et un ou plusieurs des R³⁰ à R³³ peuvent être réliés pour former un ou plusieurs cycles,
avec un composant (b) qui comprend un composé contenant de l'azote, lequel comporte au moins une fonction NH basique.

23. Procédé de préparation d'un composé de combinaison latent ou d'un sel d'ammonium latent, **caractérisé en ce qu'**on fait réagir au moins un composé contenant du phosphore (a) choisi parmi
i) les dérivés de l'acide 4-hydroxy-butane-1-phosphinique répondant à l'une des formules à cycle fermé XVI à XXI suivantes : 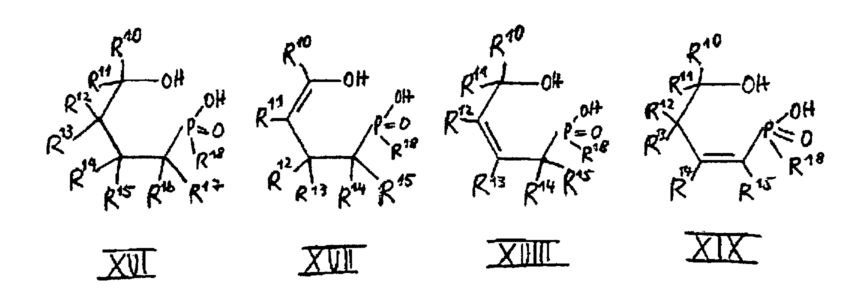 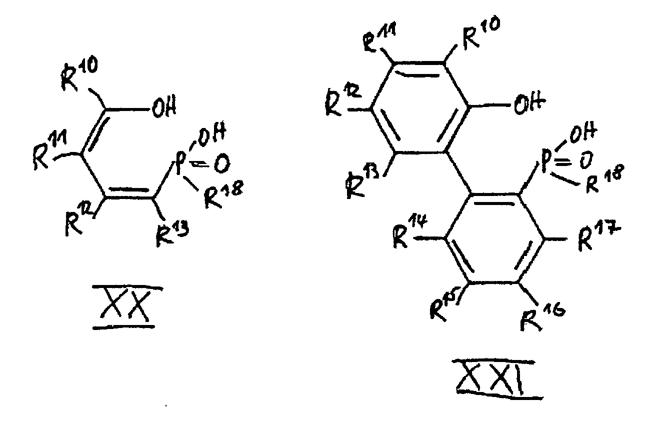 dans lesquelles les groupes R¹⁰ à R¹⁸ ont, indépendants les uns des autres, la signification générale donnée pour R⁰ dans la revendication 1, deux ou plusieurs des R¹⁰ à R¹⁷ pouvant être reliés pour former un ou plusieurs cycles, et
ii) les dérivés du phospholane répondant à l'une des formules à cycle ouvert XXXII et XXXIII suivantes : 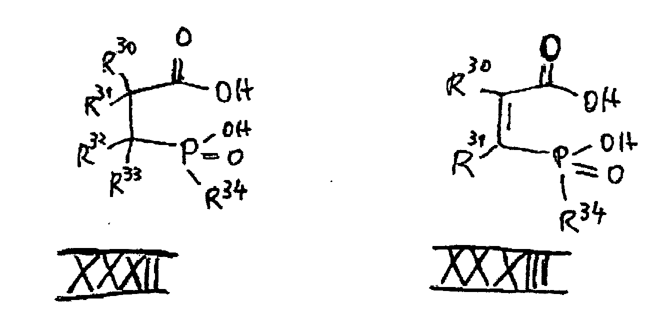 dans lesquelles les groupes R³⁰ à R³⁴ ont, indépendants les uns des autres, la signification donnée pour R⁰ dans la revendication 1, et un ou plusieurs des R³⁰ à R³³ peuvent être reliés pour former un ou plusieurs cycles,
avec un composant (b) qui comprend un composé contenant de l'azote.

24. Procédé selon l'une des revendications 21 à 23, **caractérisé en ce que** les R¹⁰ à R¹⁷ et R³⁰ à R³³, sont choisis, indépendants les uns des autres, parmi l'hydrogène et les groupements hydrocarbonés linéaires ou ramifiés aliphatiques.

25. Procédé selon la revendication 24, **caractérisé en ce que** les groupes R¹⁰ à R¹⁷ et R³⁰ à R³³ sont tous des hydrogènes.

26. Procédé selon l'une des revendications 21 à 25, **caractérisé en ce que** les groupes R¹⁸ à R³⁴ sont, indépendants les uns des autres, choisis dans le groupe constitué par l'hydrogène, le méthyle et les groupements hydrocarbonés qui comportent au moins une fonction époxy.

27. Procédé selon l'une des revendications 21 à 26, **caractérisé en ce que** dans le phospholane des formules XXX à XXXIII, les groupes R³⁰ à R³³ sont des hydrogènes, et R³⁴ est un méthyle.

28. Procédé selon l'une des revendications 22 à 27, **caractérisé en ce qu'**il comprend une réaction avec au moins un réactif choisi parmi l'eau et les composés hydroxylés mono ou polyvalents.

29. Procédé selon la revendication 21 ou 28, **caractérisé en ce que** le composé hydroxylé mono ou polyvalent est choisi parmi les phénols mono ou polyvalents et les alcools mono ou polyvalents.

30. Procédé selon la revendication 29, **caractérisé en ce que** le composé hydroxylé est choisi parmi le phénol et les alcools aliphatiques mono ou polyvalents.

31. Procédé selon l'une des revendications 22 à 29, **caractérisé en ce que** le composé contenant de l'azote est choisi dans le groupe constitué par l'imidazole, le 2-méthylimidazole et le 2-éthyl-4-méthylimidazole, ainsi que leurs sels.

32. Procédé selon l'une des revendications 21 et 23 à 30, **caractérisé en ce que** le composé contenant de l'azote est choisi dans le groupe constitué par la tétraméthyléthylènediamine, la diméthyloctylamine, le diméthylaminoéthanol, la diméthylbenzylamine, le 2,4,6-tris(diméthylaminométhyl)-phénol, le N,N'-tétraméthyldiaminodiphénylméthane, la N,N'-diméthylpipérazine, la N-méthylmorpholine, la N-méthylpipéridine, la N-éthylpyrrolidine, le 1,4-diazabicyclo[2.2.2]-octane, la quinoléine, le 1-méthylimidazole, le 1,2-diméthylimidazole, le 1,2,4,5-tétraméthylimidazole, le 1-cyanoéthyl-2-phénylimidazole et le 1-(4,6-diamino-s-triazinyl-2-éthyl)-2-phénylimidazole, et leurs sels.

33. Utilisation d'un composé de combinaison latent ou du sel d'ammonium latent selon l'une des revendications 1 à 14 et 20 ou obtenu selon le procédé de l'une des revendications 21 à 32 dans un système de résine époxy à un seul composant.

34. Utilisation selon la revendication 33, **caractérisé en ce que** le système de résine époxy à un seul composant est un matériau adhésif en résine époxy à un seul composant.

35. Système de résine époxy à un seul composant, **caractérisé en ce qu'**il comprend au moins un composant de résine époxy et au moins un composant durcisseur/accélérateur choisi parmi les composés de combinaison latents et les sels d'ammonium latents selon l'une des revendications 1 à 14 et 20 ou obtenu selon le procédé de l'une des revendications 21 à 32.

36. Matériau adhésif en résine époxy à un seul composant, **caractérisé en ce qu'**il comprend au moins un composant en résine époxy et au moins un composant durcisseur/accélérateur choisi parmi les composés de combinaison latents et les sels d'ammonium latents selon l'une des revendications 1 à 14 et 20 ou obtenu par le procédé selon l'une des revendications 21 à 32.

37. Procédé de préparation de corps moulés, d'enrobages et de collages avec des propriétés ignifugeantes, **caractérisé en ce qu'**il comprend l'utilisation d'un système de résine époxy à un seul composant selon la revendication 35 ou d'un matériau adhésif en résine époxy à un seul composant selon la revendication 36 et une étape de durcissement.

38. Corps moulés, enrobages et collages avec des propriétés ignifugeantes, **caractérisé en ce qu'**ils sont susceptibles d'être obtenus par durcissement d'un système de résine époxy à un seul composant selon la revendication 35 ou d'un matériau adhésif en résine époxy à un seul composant selon la revendication 36.

39. Procédé d'injection de résine pour des matériaux composites renforcés par des fibres et avec des propriétés ignifugeantes, **caractérisé en ce qu'**il comprend
a) l'imprégnation d'un matériau de renforcement minéral ou organique sous la forme de fibres, d'un voile, d'un tissu ou d'un matériau de surface, avec un système de résine époxy à un seul composant selon la revendication 35 et
b) le durcissement du matériau de renforcement imprégné à une température comprise entre 70 °C et 160°C.

40. Procédé selon la revendication 39, **caractérisé en ce que** le durcissement a lieu à une température comprise entre 90 °C et 140 °C.

41. Préimprégné, **caractérisé en ce qu'**il comprend un matériau de renforcement minéral ou organique sous la forme de fibres, d'un voile, d'un tissu ou d'un matériau de surface, lequel est imprégné d'un système de résine époxy à un seul composant selon la revendication 35.

42. Procédé de préparation de matériaux composites renforcés par des fibres et avec des propriétés ignifugeantes, **caractérisé en ce qu'**il comprend le durcissement d'un préimprégné selon la revendication 41 à une température comprise entre 70 °C et 160 °C.

43. Procédé selon la revendication 42, **caractérisé en ce que** le durcissement a lieu à une température comprise entre 90 °C et 140 °C.

44. Matériau composite renforcé par des fibres et avec des propriétés ignifugeantes, **caractérisé en ce qu'**il se présente sous la forme d'un préimprégné selon la revendication 41, durci.

45. Plaquette à base de préimprégné, **caractérisée en ce que** sa structure comprend au moins un matériau composite selon la revendication 44.
